(19) Europäisches Patentamt
European Patent Office
Office européen des brevets

(11) **EP 3 534 168 B1**

(12) **EUROPEAN PATENT SPECIFICATION**

(45) Date of publication and mention
of the grant of the patent:
**31.05.2023 Bulletin 2023/22**

(21) Application number: **17866215.1**

(22) Date of filing: **27.09.2017**

(51) International Patent Classification (IPC):
**G01R 31/36** (2020.01)     **H01M 10/42** (2006.01)
**H01M 10/48** (2006.01)     **H02J 7/00** (2006.01)
**G01R 31/382** (2019.01)     **G01R 31/374** (2019.01)
**B60L 58/10** (2019.01)     **B60L 58/12** (2019.01)
**B60L 58/16** (2019.01)

(52) Cooperative Patent Classification (CPC):
**G01R 31/382; B60L 58/12; B60L 58/16;**
**G01R 31/374; H01M 10/42; H01M 10/48;**
**H02J 7/00;** B60L 2240/545; B60L 2240/547;
B60L 2240/549; Y02E 60/10; Y02T 10/70

(86) International application number:
**PCT/JP2017/034856**

(87) International publication number:
**WO 2018/079164 (03.05.2018 Gazette 2018/18)**

(54) **BATTERY CONTROL DEVICE**

BATTERIESTEUERUNGSVORRICHTUNG

DISPOSITIF DE COMMANDE DE BATTERIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **26.10.2016 JP 2016209669**

(43) Date of publication of application:
**04.09.2019 Bulletin 2019/36**

(73) Proprietor: **Vehicle Energy Japan Inc.
Hitachinaka-shi
Ibaraki-ken 3128505 (JP)**

(72) Inventors:
• **AKATSU, Miyuki
Ibaraki-ken 312-8505 (JP)**
• **OHKAWA, Keiichiro
Ibaraki-ken 312-8505 (JP)**
• **NAKAO, Ryohhei
Ibaraki-ken 312-8505 (JP)**

(74) Representative: **Strehl Schübel-Hopf & Partner
Maximilianstrasse 54
80538 München (DE)**

(56) References cited:
WO-A1-2012/169063     WO-A1-2016/013241
JP-A- 2003 151 643     JP-A- 2007 292 648
JP-A- 2007 311 065     JP-A- 2015 059 816
US-A1- 2012 035 873     US-A1- 2013 200 845
US-A1- 2014 055 100     US-A1- 2014 145 684
US-A1- 2014 303 915

## Description

**Technical Field**

The present invention relates to a battery control device.

**Background Art**

In estimating of a state of charge SOCv based on battery voltage, in general, an open-circuit voltage OCV of the present battery is calculated from a battery state parameter such as a closed-circuit voltage CCV of the battery, a battery current I, and a battery temperature T, and the state of charge SOCv is obtained using an OCV-SOC battery characteristic map. PTL 1 discloses a method of calculating a remaining capacity of a battery in a case where a temperature distribution occurs in the battery. In the description of PTL 1, an SOC correction value of a self-discharging amount is calculated by a difference between a high temperature and a low temperature on the basis of a relation between the battery temperature and the self-discharging amount so as to reduce the SOC difference.
The document US 2012/35873 A1 discloses a battery control device including a first SOC estimating unit estimating a first SOC by current integration and a second SOC estimating unit using correlations between the open-circuit voltage/temperature and SOC.
The document US 2013/0200845 A1 discloses a hybrid vehicle including a battery state detecting unit detecting a temperature and SOC of a battery pack and acquiring a target SOC corresponding to the detected temperature.

Citation List

Patent Literature

PTL 1: JP 2012-026869 A

Summary of Invention

Technical Problem

However, in a battery having the temperature distribution, an input temperature is not uniquely determined. Therefore, when a representative temperature is set to one point to estimate an internal resistance, for example, an error from the actual internal resistance is necessarily generated. In a case where the estimation error of the internal resistance at this time is large, and the SOC estimation error calculated using the internal resistance estimation value is increased, there is a concern that a control is performed departing from a range of battery use.

Solution to Problem

According to an aspect of the invention, there is provided a battery control device which includes a first SOC calculation unit which calculates a first battery charging state on the basis of a temperature and a voltage value of a battery, and a second SOC calculation unit which calculates a second battery charging state on the basis of a current value of the battery. Charging/discharging of the battery is controlled on the basis of a third battery charging state based on the first battery charging state and the second battery charging state. The temperature includes a plurality of temperatures measured at plural positions of the battery. The first SOC calculation unit switches a first mode in which an SOC calculation of the battery is performed on the basis of a first temperature on a high temperature side of the battery and a second mode in which the SOC calculation of the battery is performed on the basis of a second temperature on a low temperature side of the battery, on the basis of a magnitude of the second temperature.

Advantageous Effects of Invention

According to the invention, it is possible to suppress a degradation of a battery caused by an influence of an SOCv estimation error.

Brief Description of Drawings

[FIG. 1] FIG. 1 is a block diagram illustrating a configuration of a battery system.

[FIG. 2] FIG. 2 is a block diagram illustrating a battery state estimation unit.

[FIG. 3] FIG. 3 is a diagram illustrating an equivalent circuit of a cell.

[FIG. 4] FIG. 4 is a diagram illustrating a relation between an open-circuit voltage OCV and a state of charge SOC in the cell.

[FIG. 5] FIG. 5 is a block diagram for describing a configuration of an SOCv calculation unit.

[FIG. 6] FIG. 6 is a diagram illustrating a layout of temperature sensors.

[FIG. 7] FIG. 7 is a block diagram illustrating a configuration of a temperature selection unit according to a first embodiment.

[FIG. 8] FIG. 8 is a diagram for describing an operation of a mode switching determination unit.

[FIG. 9] FIG. 9 is a flowchart illustrating a processing flow of the mode switching determination unit.

[FIG. 10] FIG. 10 is a diagram illustrating a time transition of a first mode temperature Tmode1 and a battery temperature (second mode temperature) Tmodo2 according to the first embodiment.

[FIG. 11] FIG. 11 is a diagram for describing a magnitude relation between an internal resistance true value Rtr and internal resistance estimation values R_l and R_h.

[FIG. 12] FIG. 12 is a diagram for describing an open-circuit voltage estimation value in a case where an input temperature Tin is Tin_l (< Ttr).

[FIG. 13] FIG. 13 is a diagram for describing the open-circuit voltage estimation value in a case where the input temperature Tin is Tin_h (> Ttr).

[FIG. 14] FIG. 14 is diagram for describing a relation between SOCchgest, SOCchgtr1, and SOCchgtr2, and a relation between SOCdisest, SOCdistr1, and SOCdistr2.

[FIG. 15] FIG. 15 is a flowchart illustrating a modification of the process illustrated in FIG. 9.

[FIG. 16] FIG. 16 is a diagram illustrating a time transition of the first mode temperature Tmode1 and the second mode temperature Tmode2 in a cooling mode.

[FIG. 17] FIG. 17 is a block diagram of the temperature selection unit according to a second embodiment.

[FIG. 18] FIG. 18 is a flowchart illustrating a processing flow of the mode switching determination unit according to the second embodiment.

[FIG. 19] FIG. 19 is a block diagram of the temperature selection unit according to a third embodiment.

[FIG. 20] FIG. 20 is a flowchart illustrating a processing flow of the mode switching determination unit according to the third embodiment.

[FIG. 21] FIG. 21 is a graph illustrating a time transition of the input temperature Tin according to the third embodiment.

[FIG. 22] FIG. 22 is a block diagram of the temperature selection unit according to a fourth embodiment.

[FIG. 23] FIG. 23 is a diagram illustrating an example of a weight W which is generated by a W generator.

[FIG. 24] FIG. 24 is a graph illustrating a time transition of the input temperature Tin in warming.

[FIG. 25] FIG. 25 is a block diagram of the temperature selection unit according to a fifth embodiment.

Description of Embodiments

Hereinafter, embodiments of the invention will be described with reference to the drawings.

- First Embodiment -

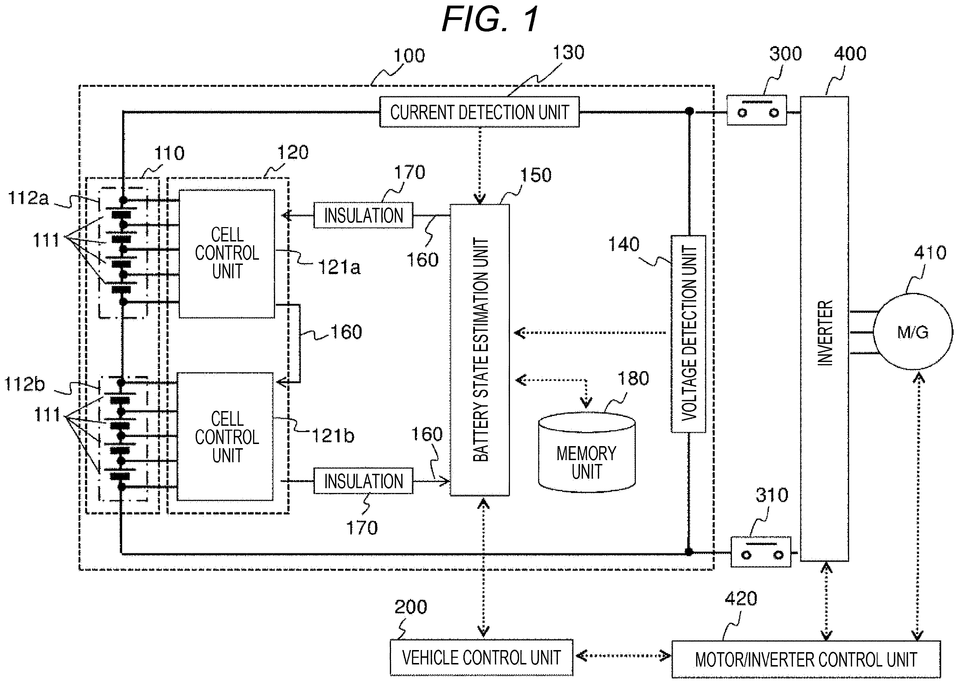

FIG. 1 is a diagram illustrating a first embodiment of the invention, and is a block diagram illustrating a configuration of a battery system. A battery system 100 is a system to supply power to an external target which includes an electric vehicle, a hybrid vehicle, a railway car, and an industrial machine. In FIG. 1, there is illustrated a case where the power is supplied to a motor generator 410 for driving the hybrid vehicle.

The battery system 100 is connected to an inverter 400 through relays 300 and 310. The inverter 400 supplies the power from the battery system 100 to the motor generator 410. The inverter 400 and the motor generator 410 are controlled by a motor/inverter control unit 420. A vehicle control unit 200 determines a distribution of driving forces on the basis of battery information obtained by the battery system 100, information from the inverter 400 and the motor generator 410, and information from an engine (not illustrated).

The battery system 100 includes a battery pack 110 which is configured by a plurality of cells 111, a measurement unit 120 which includes a plurality of cell control units 121 to monitor the state of the cell 111, a current detection unit 130 which detects the current flowing to the battery pack 110, a voltage detection unit 140 which detects a total voltage of the battery pack 110, a battery state estimation unit 150 which controls the battery pack 110, and a memory unit 180 which stores information related to battery characteristics of the battery pack 110, the cell 111, and a cell group 112.

The plurality of cells 111 of the battery pack 110 is grouped into a predetermined number of cells. In the example illustrated in FIG. 1, the plurality of cells 111 are grouped into two cell groups 112a and 112b. The cell groups 112a and 112b are electrically connected in series.

Further, the cell 111 is a chargeable battery such as a lithium-ion secondary battery. As the cell 111, a storage battery such as nickel hydrogen battery, a lead battery, an electrical double-layer capacitor, and a device having an electricity storage function may be considered. Herein, a unit cell will be considered as the cell 111. However, the cell 111 may be replaced with a module structure in which a plurality of batteries are connected in multivalued manner or in parallel.

In addition, in the example illustrated in FIG. 1, two cell groups 112a and 112b are configured to be connected in series as the battery pack 110. However, the invention is not limited to the configuration, a predetermined number of cell groups may be connected in series or in parallel. In addition, various combinations of the number of cell groups may be configured in series or in parallel according to applications.

The measurement unit 120 is used to monitor the state of each cell 111 of the battery pack 110. The same number of cell control units 121a and 121b are provided in correspondence with the plurality of cell groups 112a and 112b. The cell control unit 121a is assigned to the cell group 112a, and the cell control unit 121b is assigned to the cell group 112b. The cell control units 121a and 121b receive power from the respectively assigned cell groups 112a and 112b, and operate. The cell control units 121a and 121b monitor battery voltages and battery temperatures of the respectively assigned cell groups 112a and 112b.

The battery state estimation unit 150 receives a current value flowing to the battery pack 110 which is transmitted from the current detection unit 130, and a total voltage value of the battery pack 110 which is transmitted from the voltage detection unit 140. In addition, the battery state estimation unit 150 transfers a signal with the measurement unit 120 by a signal communication unit 160 and, receives, from the measurement unit 120, the battery voltage and the battery temperature of the cell 111, a diagnosis result indicating whether the cell 111 is overcharged or overdischarged, and an abnormality signal which is output in a case where a communication error occurs in the measurement unit 120. The battery state estimation unit 150 performs a process such as a battery state estimation on the basis of the input information, and transmits the processing result to the measurement unit 120 and the vehicle control unit 200.

Further, the signal communication unit 160 is provided with an insulation element 170 such as a photo coupler. As described above, the measurement unit 120 operates by the power received from the battery pack 110 while the battery state estimation unit 150 uses a battery for car equipment (for example, 12V battery) as a power source. Therefore, the reference voltages of the operation voltages of the battery state estimation unit 150 and the measurement unit 120 are different. Therefore, the insulation element 170 is provided in the signal communication unit 160. The insulation element 170 may be mounted in a circuit board of the measurement unit 120, or may be mounted in a circuit board of the battery state estimation unit 150. Further, the insulation element 170 may be omitted depending on a system configuration.

The cell control units 121a and 121b are connected in series according to an descending order of the potentials of the cell groups 112a and 112b which are monitored. The insulation element 170 is not provided between the output of the cell control unit 121a and the input of the cell control unit 121b. This is because the cell control units 121a and 121b are provided with a mechanism which can communicate even between the different operation reference potentials. However, in a case where there is required an electrical insulation for the communication between the cell control unit 121a and the cell control unit 121b, there is a need to provide the insulation element 170.

The signal transmitted by the battery state estimation unit 150 is input to the cell control unit 121a by the signal communication unit 160 which is provided with the insulation element 170. The output signal from the cell control unit 121b is sent to the input unit of the battery state estimation unit 150 by the signal communication unit 160 which is provided with the insulation element 170. In this way, the battery state estimation unit 150 and the cell control units 121a and 121b are connected in a loop shape by the signal communication unit 160. Such a connection and communication manner is called a daisy chain connection, or may be called a rosary beading connection or a one-after-another connection.

The memory unit 180 stores information related to the battery pack 110, the cell 111, and the cell group 112, such as internal resistance characteristics, a capacity at the time of charging, polarization resistance characteristics, degradation characteristics, individual difference information, and a correspondence (OCV-SOC map) between an open-circuit voltage OCV of the battery and a state of charge SOC of the battery. Further, in the example illustrated in FIG. 1, the memory unit 180 is disposed on the outer side of the battery state estimation unit 150 and the measurement unit 120. However, the memory unit 180 may be provided in the battery state estimation unit 150 or the measurement unit 120.

(Battery State Estimation Unit 150)

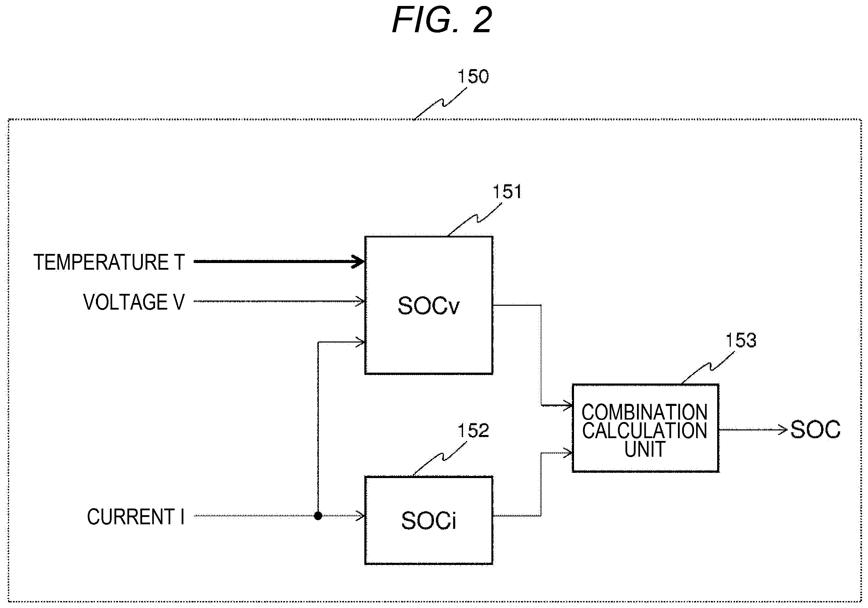

FIG. 2 is a block diagram illustrating the battery state estimation unit 150. The battery state estimation unit 150 includes an SOCv calculation unit 151, an SOCi calculation unit 152, and a combination calculation unit 153. The SOCv calculation unit 151 receives a voltage (an average voltage of each cell 111) of the cell 111 of the battery pack 110, a current flowing to the battery pack 110, and a temperature obtained by the battery pack 110. Herein, the input voltage of the cell 111 is an average voltage of the voltages of the plurality of cells 111 which are included in the battery pack 110. The SOCv calculation unit 151 calculates and outputs a state of charge SOCv of the battery on the basis of the battery voltage. Further, the details of the SOCv calculation unit 151 will be described below.

The SOCi calculation unit 152 receives a current flowing to the battery pack 110. The SOCi calculation unit 152 calculates a current accumulation amount obtained by integrating the current flowing to the battery pack 110 with time, obtains a state of charge SOCi of the battery by adding or subtracting the current accumulation amount with respect to the previous value of the SOCi calculation result, and outputs the calculated state of charge SOCi.

The combination calculation unit 153 calculates a final state of charge SOC which is a more probable value of the battery from the state of charge SOCv which is the output of the SOCv calculation unit 151 and the state of charge SOCi which is the output of the SOCi calculation unit 152.

In general, the state of charge SOCv calculated by the SOCv calculation unit 151 has a feature that the SOC estimation error is small in a case where the current is stable such as a case where the current flowing to the battery pack 110 is zero or a constant current keeps flowing for a predetermined time or more. On the contrary, the SOC estimation error is easily increased in a case where the current greatly fluctuates or in a case where the battery temperature is low. On the other hand, the state of charge SOCi calculated by the SOCi calculation unit 152 has a feature that the SOC estimation error is small in a case where the current is large and has no great fluctuation. On the contrary, the SOC estimation error is easily increased in a case where the current value is small to be easily influenced by the measurement accuracy of the current detection unit 130.

Therefore, the combination calculation unit 153 adjusts an influence degree to the final state of charge SOC by using weights on the features of the state of charge SOCv and the state of charge SOCi. With this configuration, it is possible to improve the SOC estimation accuracy.

(Basic Operation of SOCv Calculation Unit 151)

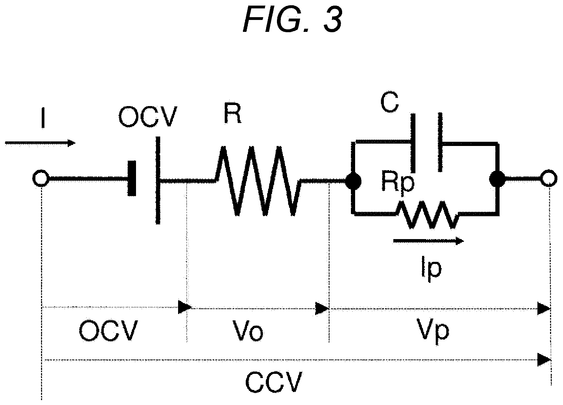

Next, the operation of the SOCv calculation unit 151 will be described. FIG. 3 is a diagram illustrating an equivalent circuit of the cell 111. The cell 111 can be represented by a parallel connection of a polarization resistance component Rp and a polarization capacitance component C, and a series connection of an internal resistance R and the open-circuit voltage OCV of the cell 111. In FIG. 3, Vp represents a polarization voltage, and corresponds to a voltage of both ends of the parallel connection of the polarization resistance component Rp and the polarization capacitance component C. When a current I is applied to the cell 111, a closed-circuit voltage CCV of the battery can be represented by Expression (1).

$$CCV = OCV + R \cdot I + Vp \ ... \ (1)$$

The open-circuit voltage OCV is used for the calculation of the state of charge SOCv, but it is not possible for the measurement unit 120 to directly measure the open-circuit voltage OCV. Therefore, as the following Expression (2), the open-circuit voltage OCV is obtained by subtracting R·I (IR drop amount) and a polarization voltage Vp from the measured closed-circuit voltage CCV.

$$OCV = CCV - R \cdot I - Vp \ ... \ (2)$$

As described above, battery characteristic information related to the internal resistance R and the polarization voltage Vp is stored in the memory unit 180 in advance. Further, the internal resistance R and the polarization voltage Vp vary depending on the charging states and the temperatures of the cell 111, the cell group 112, and the battery pack 110. Therefore, the battery information obtained from the measurement unit 120, the current detection unit 130, and the voltage detection unit 140 is input, and stored in the memory unit 180 as values individually corresponding to a combination of the charging state and the temperature. In this embodiment, the internal resistance R is obtained from an internal resistance map which defines a correspondence between the temperature and the internal resistance. The details of the temperature used for the calculation of the internal resistance R will be described below.

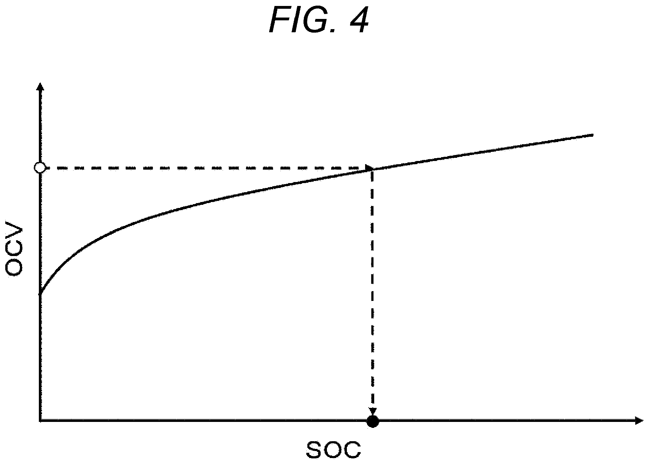

FIG. 4 is a diagram illustrating a relation between the open-circuit voltage OCV and the state of charge SOC in the cell 111. The correspondence between the open-circuit voltage OCV and the state of charge SOC illustrated in FIG. 4 is determined by a battery characteristic, and stored in the memory unit 180 as an OCV-SOC map. The SOCv calculation unit 151 of FIG. 3 calculates the OCV using Expression (2) from the closed-circuit voltage CCV obtained by the measurement unit 120, and calculates the corresponding state of charge SOCv from the calculated open-circuit voltage OCV and the OCV-SOC map of FIG. 4.

In FIGS. 3 and 4, a method of obtaining the state of charge SOCv of the cell 111 has been described. However, the same method may be applied to a case where an average state of charge SOCv in the battery pack 110 and the cell group 112 is obtained. In the SOCv calculation unit 151 in this embodiment, an average closed-circuit voltage CCV in the battery pack 110 is input, and an average state of charge SOCv of the battery pack 110 is calculated using the OCV-SOC map and is output.

(Configuration of SOCv Calculation Unit 151)

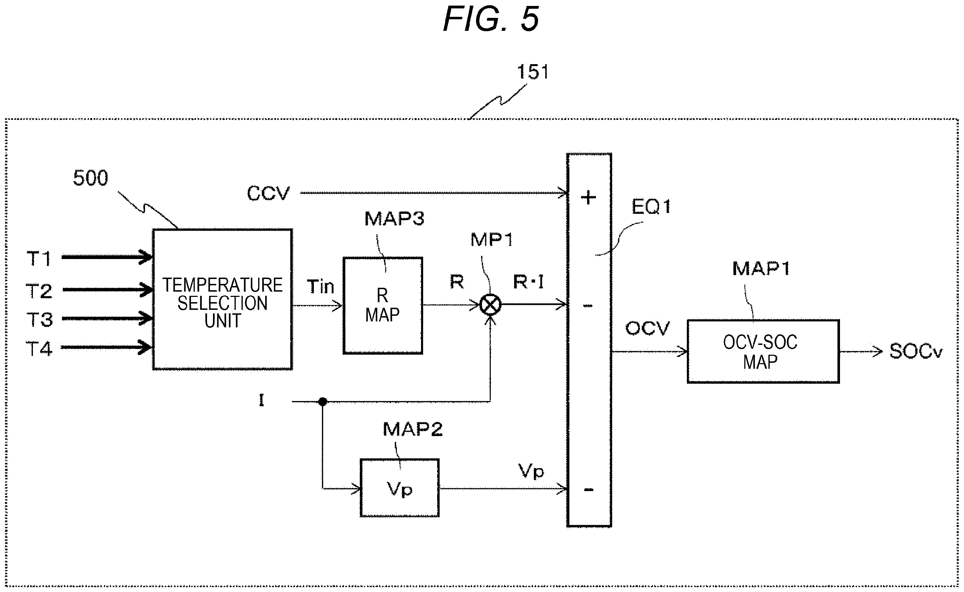

FIG. 5 is a block diagram for describing the configuration of the SOCv calculation unit 151. The SOCv calculation unit 151 calculates the average state of charge SOCv of the battery pack 110 from the OCV-SOC map MAP1 following the OCV-SOC relation of FIG. 3 and the open-circuit voltage OCV. The open-circuit voltage OCV herein is an average open-circuit voltage OCV of the battery pack 110. The open-circuit voltage OCV is calculated in a calculation block EQ1 based on Expression (2). When the closed-circuit voltage CCV detected by the voltage detection unit 140, the R·I drop from a multiplier MP1, and the polarization voltage Vp from a map MAP2 are input to the calculation block EQ1, the open-circuit voltage OCV is output.

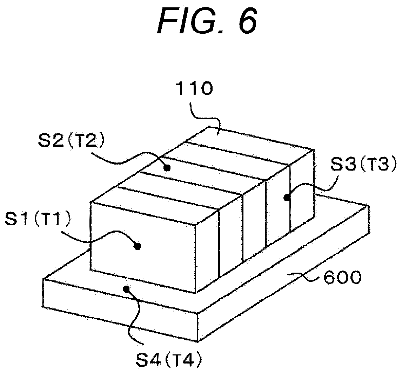

One or plural temperature sensors are provided to monitor the battery temperature near the cell 111, the cell group 112, the battery pack 110, or the battery. FIG. 6 is a diagram illustrating a layout of the temperature sensors in this embodiment. In general, it is known that the battery performance is degraded when the battery is high or low in temperature. Therefore, it is widely performed that the temperature of the battery is adjusted by warming or cooling the battery in order to make use of the battery performance.

In the example illustrated in FIG. 6, a heat transfer member 600 is connected to the bottom of the battery pack 110. The battery pack 110 is warmed or cooled by transferring heat with the battery pack 110 and the heat transfer member 600. Further, in this embodiment, the battery pack 110 is directly connected to the heat transfer member 600 which is a fixed member. However, the heat transfer member may be a fluid (gas or liquid) or may have any shape as long as the material can transfer heat. In addition, a member (for example, an electric heating sheet, grease, etc.) may be interposed between the battery pack 110 and the heat transfer member 600 to make the heat transfer easy.

A plurality of temperature sensors S1 to S4 are attached to the battery pack 110 and the heat transfer member 600, and can acquire the temperatures T1 to T4 at plural places. In this embodiment, the temperature sensors S1 to S3 are attached at predetermined positions of the battery pack 110. The temperature sensor S4 is attached to a predetermined position of the heat transfer member 600. However, the number and the positions of temperature sensors are not limited to the configuration illustrated in FIG. 5. Further, in this embodiment, in a case where a temperature distribution occurs in the battery pack 110, it is considered that it is found in advance that the temperature T4 is suitable to express a high temperature of the battery. Therefore, in this embodiment, the temperature sensor S4 is disposed in the heat transfer member 600. However, for example, the temperature sensor S4 may be disposed in a portion of the battery pack 110 where the heat transfer member 600 abuts and a portion near that portion.

Returning to FIG. 5, the battery temperature detected by the temperature sensor is input to a temperature selection unit 500 of the SOCv calculation unit 151. In the example illustrated in FIG. 5, four temperatures T1 to T4 related to the battery are input. The temperature selection unit 500 outputs an input temperature Tin which is input to an internal resistance map MAP3 as a representative temperature of the battery on the basis of the input temperatures T1 to T4. Further, the detail setting of the input temperature Tin in the temperature selection unit 500 will be described below.

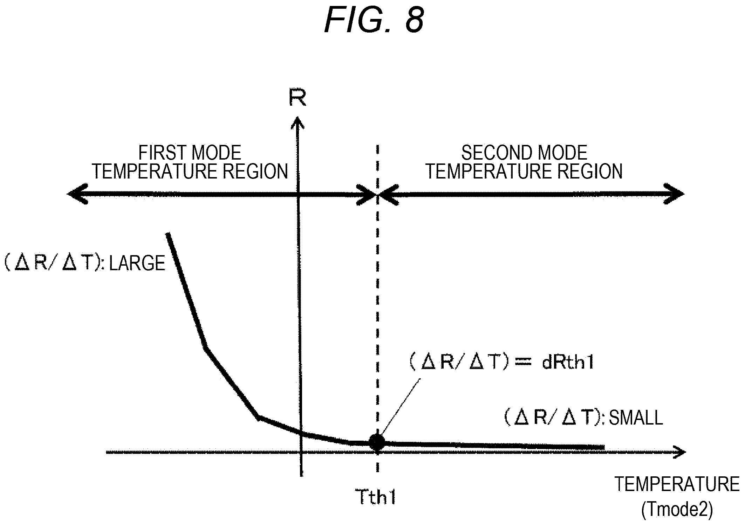

An internal resistance estimation value R corresponding to the input temperature Tin is obtained by inputting the input temperature Tin output from the temperature selection unit 500 to the internal resistance map MAP3. The internal resistance map MAP3 is a map obtained from the relation between the internal resistance and the temperature of the battery as illustrated in FIG. 8. In FIG. 8, the horizontal axis represents temperature, and the vertical axis represents internal resistance. An current value I of the current flowing in the battery pack 110 detected by the current detection unit 130 and the internal resistance estimation value R output from the internal resistance map MAP3 are multiplied by the multiplier MP1, and the R·I drop is obtained. The R·I drop is input to the calculation block EQ1. In addition, the polarization voltage Vp input to the calculation block EQ1 is obtained by the map MAP2 which receives the current I of the battery obtained by the current detection unit 130 and calculates the polarization voltage Vp.

(Temperature Selection Unit 500)

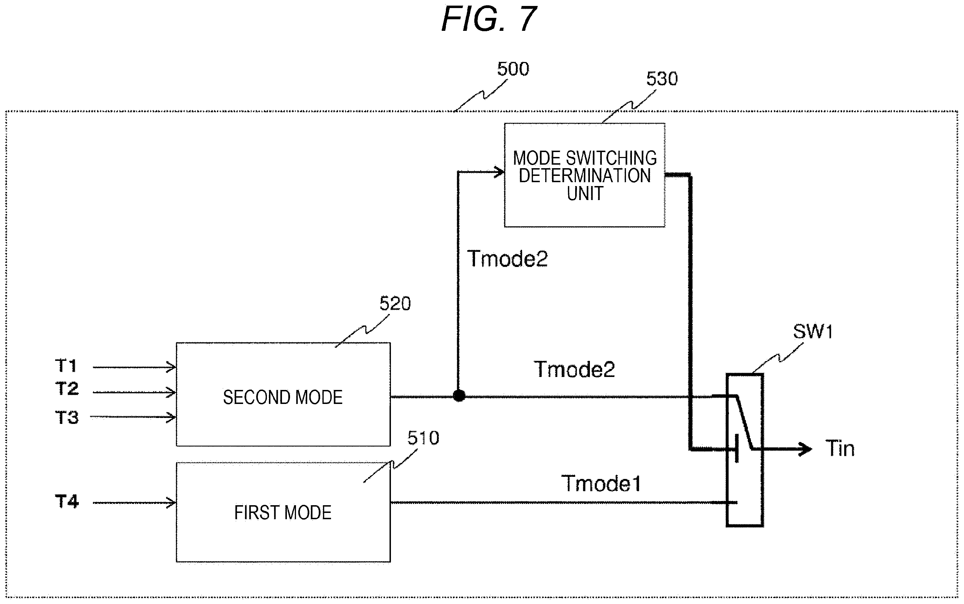

FIG. 7 is a block diagram illustrating a configuration of the temperature selection unit 500 in this embodiment. The temperature selection unit 500 includes a first mode calculation unit 510, a second mode calculation unit 520, a mode switching determination unit 530, and a switch SW1. The temperature T4 from the temperature sensor S4 disposed in the heat transfer member 600 is input to the first mode calculation unit 510. The temperatures T1 to T3 from the temperature sensors S1 to S3 disposed in the battery pack 110 are input to the second mode calculation unit 520. The first mode calculation unit 510 outputs the input temperature T4 as a first mode temperature Tmode1. The second mode calculation unit 520 outputs an average temperature of the input temperatures T1 to T3 as a second mode temperature Tmode2 which represents the temperature of the battery pack 110. In the following, the second mode temperature Tmode2 may be called the battery temperature. The mode switching determination unit 530 switches the switch SW1 as described below on the basis of the input battery temperature Tmode2, and outputs any one of the first mode temperature Tmode1 and the battery temperature Tmode2 as the input temperature Tin from the switch SW1.

As described above, in this embodiment, the temperature T4 of the heat transfer member 600 is not included in the calculation of the average temperature in the second mode calculation unit 520. However, the temperature T4 may also be included in the second mode to set the average temperature of the temperatures T1 to T4 as the second mode temperature Tmode2. This configuration is used in a case where the average temperature of the battery pack 110 is not suitable when the average temperature of the battery pack 110 using only the temperatures T1 to T3 due to an influence of the positions where the temperature sensors S1 to S3 are attached. For example, this is because, in a case where the temperature sensors S1 to S3 are disposed at positions where extremely low temperatures are obtained in the temperature distribution generated in the battery pack 110, it is considered that the average temperature to be obtained becomes significantly lower than the average temperature of the actual battery pack 110 without taking consideration of the influence of a temperature difference.

Further, as described above, it is found in advance that the temperature T4 is suitable to indicate the high temperature of the battery in a case where the temperature distribution occurs in the battery pack 110. Therefore, in a case where the temperature distribution occurs in the battery pack 110, the high temperature of the battery is output as the first mode temperature Tmode1.

Next, the operation of the mode switching determination unit 530 will be described using FIG. 8. FIG. 8 is a graph illustrating a relation (that is, the internal resistance map MAP3) between the internal resistance R in the cell 111 and the temperature of the cell 111. The relation between the internal resistance and the temperature can be represented by an exponential curve as illustrated in FIG. 8. As the temperature of the cell 111 is increased, the internal resistance R becomes small. As the temperature is decreased, the internal resistance R becomes large. In addition, regarding the change rate ($\Delta R/\Delta T$) of the internal resistance R, as the temperature of the cell 111 is increased, the change rate ($\Delta R/\Delta T$) of the internal resistance R is decreased. As the temperature is decreased, the change rate ($\Delta R/\Delta T$) of the internal resistance R is increased.

In addition, the battery pack 110, the cell group 112, and the cell 111 used in this embodiment show the similar tendency in the relation between the internal resistance R and the temperature. In other words, the average temperature of the plurality of cells 111 in the battery pack 110 and the cell group 112 and the average internal resistance of the plurality of cells 111 can also be described similarly using the graph of FIG. 8.

In the description of the SOCv calculation unit 151 in FIG. 5, the method of obtaining the state of charge SOCv of the cell 111 has been described as a basic operation. However, the same method may be applied in the case of obtaining an average state of charge SOCv in the battery pack 110 and the cell group 112. In the SOCv calculation unit 151 used in this embodiment, the average open-circuit voltage CCV in the battery pack 110 is input, and the average state of charge SOCv is calculated using the OCV-SOC map and output. Therefore, in this embodiment, the temperature of the horizontal axis of FIG. 8 corresponds to the battery temperature (the second mode temperature) Tmode2 which is output from the second mode calculation unit 520.

In FIG. 8, the temperature region is divided into a first mode temperature region on a low temperature side and a second mode temperature region on a high temperature side with a predetermined temperature Tth1 as a boundary. In a case where the battery temperature Tmode2 is in the first mode temperature region, the mode switching determination unit 530 switches the switch SW1 such that the first mode temperature Tmode1 output from the first mode calculation unit 510 is output as the input temperature Tin from the switch SW1. On the other hand, in a case where the battery temperature Tmode2 is in the second mode temperature region, the mode switching determination unit 530 switches the switch SW1 such that the battery temperature (the first mode temperature) Tmode2 is output from the switch SW1 as the input temperature Tin from the second mode calculation unit 520.

The predetermined temperature Tth1 divided into the first mode temperature region and the second mode temperature region is determined as follows. As illustrated in FIG. 8, the change rate ($\Delta R/\Delta T$) of the internal resistance R is increased as the temperature of the battery is decreased. This indicates that, in a case where the battery temperature Tmode2 is a normal temperature or a high temperature, the internal resistance R can be estimated with accuracy even if there is a certain degree of error in the battery temperature Tmode2. On the contrary, in a case where the battery temperature Tmode2 is a low temperature, the estimation error of the internal resistance R caused by the error of the battery temperature Tmode2 becomes large, and the internal resistance R is hard to estimate. In other words, as the temperature is decreased, the battery use situation easily departs from an SOC use range due to the SOC estimation error.

Therefore, a predetermined value dRth1 is introduced to the change rate ($\Delta R/\Delta T$) of the internal resistance R with respect to the battery temperature Tmode2. A temperature range satisfying the following Expression (3) is set to the first mode temperature region. A range satisfying the following Expression (4) is set to the second mode temperature region. The predetermined temperature Tth1 in the battery temperature corresponding to the predetermined value dRth1 can be uniquely obtained.

$$(\Delta R/\Delta T) > dRth1 \ldots (3)$$

$$(\Delta R/\Delta T) \leq dRth1 \ldots (4)$$

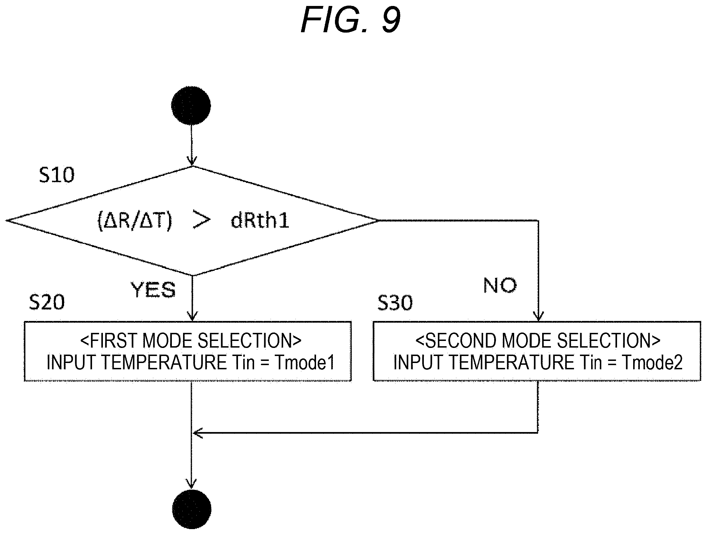

FIG. 9 is a diagram illustrating a processing flow of the mode switching determination unit 530 based on the change rate of the internal resistance R. In Step S10, the change rate $(\Delta R/\Delta T)$ in the battery temperature Tmodo2 input from the second mode calculation unit 520 is obtained, and it is determined whether the obtained change rate $(\Delta R/\Delta T)$ satisfies the condition of Expression (3). Further, in the memory unit 180 of FIG. 1, a map indicating the correspondence between the battery temperature and the change rate $(\Delta R/\Delta T)$ is stored in advance, and the change rate $(\Delta R/\Delta T)$ is obtained using the map. In a case where the condition of Expression (3) is satisfied, the process proceeds from Step S10 to Step S20. The switch SW1 is switched such that the first mode temperature Tmode1 output from the first mode calculation unit 510 is output as the input temperature Tin. On the other hand, in a case where the condition of Expression (3) is not satisfied, the process proceeds to Step S30. The switch SW1 is switched such that the battery temperature (the second mode temperature) Tmode2 output from the second mode calculation unit 520 is output as the input temperature Tin.

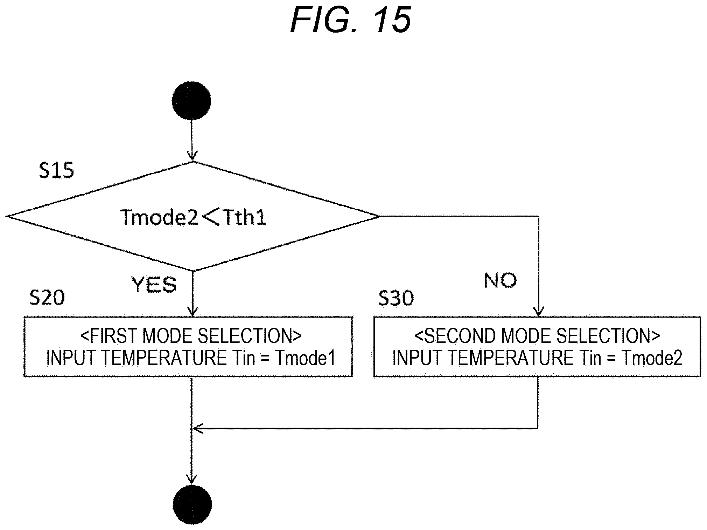

Further, in the process illustrated in FIG. 9, the change rate $(\Delta R/\Delta T)$ is obtained from the input battery temperature Tmodo2 as in Step S10. The magnitudes of the change rate $(\Delta R/\Delta T)$ and the predetermined value dRth1 are compared. However, as the processing flow illustrated in FIG. 15, the magnitudes of the battery temperature Tmode2 and the input temperature Tin may be compared. In FIG. 15, it is determined whether Tmode2 < Tth1 is satisfied in Step S15. In a case where Tmode2 < Tth1 is satisfied, the process proceeds to Step S20. In a case where Tmode2 $\geq$ Tth1 is satisfied, the process proceeds to Step S30.

In other words, in the case of Tmode2 $\geq$ Tth1, even if the battery temperature Tmode2 is employed to the temperature when the internal resistance R is calculated (the input temperature Tin), the internal resistance R can be calculated with accuracy. It is possible to suppress an SOC estimation error. Therefore, the switch SW1 is switched to output the battery temperature Tmode2 as the input temperature Tin.

On the other hand, in the case of Tmode2 < Tth1, the change rate $(\Delta R/\Delta T)$ of the internal resistance is large. Therefore, when the battery temperature Tmode2 is used as the input temperature Tin, the SOC estimation error becomes large. As a result, there is a concern that the true value of SOC departs from a recommended SOC range. Therefore, such a defect is prevented by using the temperature T4 (= first mode temperature Tmode1) indicating a high temperature of the battery in this embodiment. The details of using of the temperature T4 will be described below. Further, in this embodiment, as described above, in a case where the temperature distribution occurs in the battery pack 110, it is found in advance that the temperature T4 is suitable to indicate the high temperature of the battery.

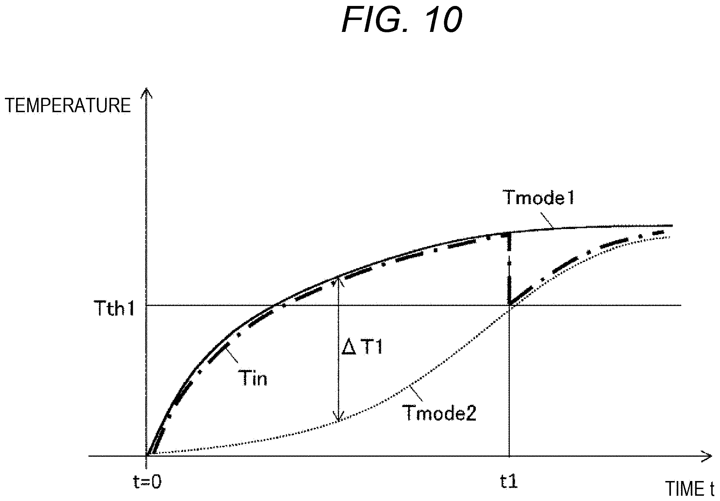

FIG. 10 is a diagram illustrating time transitions of the first mode temperature Tmode1, the battery temperature (the second mode temperature) Tmodo2, and the input temperature Tin in the first embodiment. Herein, the description will be given about a case where the heat transfer member 600 functions as a warming system. In FIG. 10, the curve attached with Symbol Tmode1 represents a time transition of the first mode temperature Tmode1 (= T4) output from the first mode calculation unit 510, and the curve attached with Symbol Tmode2 represents a time transition of the battery temperature (the second mode temperature) Tmode2 output from the second mode calculation unit 520. The curve depicted with a chain line represents a time transition of the input temperature Tin.

The temperatures T1 to T4 are almost equal at the time of starting the warming (t = 0) (see FIG. 6), so that the first mode temperature Tmode1 (the temperature T4) and the battery temperature Tmode2 (the average temperature of the temperatures T1 to T3) are the same temperature. After the starting of the warming, a temperature difference $\Delta$T1 between the first mode temperature Tmode1 and the battery temperature Tmode2 is increased with time. This indicates that the battery pack 110 is not sufficiently heated while the heat transfer member 600 is heated and steeply increased in temperature as the warming starts.

However, when a sufficient time elapses after the warming starts, the battery temperature Tmode2 gradually approaches the first mode temperature Tmode1. This indicates that the heat of the heat transfer member 600 is sufficiently transferred to the battery pack 110 by the continuous warming. Finally, the first mode temperature Tmode1 and the battery temperature Tmode2 are assumed to be almost the same temperature level.

As described above, in a case where the battery temperature Tmode2 satisfies Tmode2 < Tth1 with respect to the predetermined temperature Tth1, the first mode temperature Tmode1 is output as the input temperature Tin from the switch SW1. Therefore, the curve Tin is matched with the curve Tmode1 until time t1 at which Tmode2 = Tth1 is satisfied. On the other hand, since Tmode2 $\geq$ Tth1 is satisfied at t $\geq$ t1, the curve Tin is matched with the curve Tmode2.

(Influence of Temperature Estimation Error)

By the way, in a situation where the SOC estimation error is large, an SOC estimation value may be deviated to be larger or smaller than an SOC true value. The battery pack is degraded easily or not depending on the deviation direction. In a situation where a temperature distribution or a temperature error occurs in the battery pack 110 by the heat of the heat transfer member 600 like the case of the warming, the temperature true value of the battery pack 110 is hard to acquire. The input temperature Tin used in estimating the internal resistance is assumed to be any one of the magnitude relations of the following Expressions (5) and (6) with respect to the temperature true value Ttr of the battery pack 110.

$$(\text{Input Temperature Tin}) < (\text{Temperature True Value Ttr}) \ ... \ (5)$$

$$(\text{Temperature True Value Ttr}) < (\text{Input Temperature Tin}) \ ... \ (6)$$

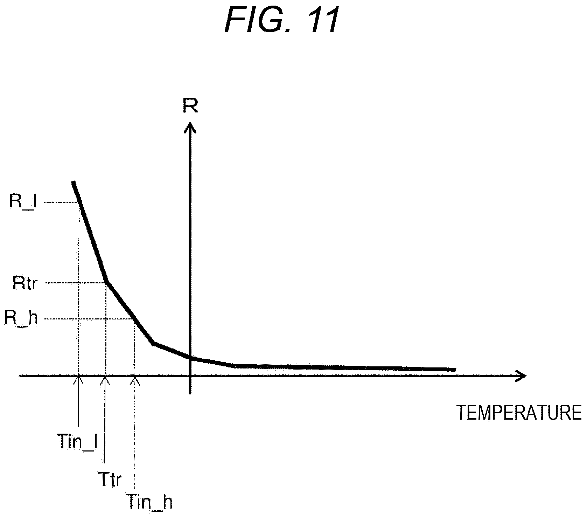

FIG. 11 is obtained if the above relations are illustrated into a graph (corresponding to the internal resistance map MAP3) illustrating a relation between the temperature and the internal resistance illustrated in FIG. 8. If the input temperature Tin in the relation of Expression (5) is set to Tin_l, the magnitude relation between an internal resistance estimation value R_l and an internal resistance true value Rtr at the input temperature Tin_l is obtained as Expression (7). In addition, if the input temperature Tin in the relation of Expression (6) is set to Tin_h, the magnitude relation between an internal resistance estimation value R_h and an internal resistance true value Rtr at the input temperature Tin_l is obtained as Expression (8).

$$(\text{Internal Resistance True Value Rtr}) < (\text{Internal Resistance Estimation Value R\_l}) \ ... \ (7)$$

$$(\text{Internal Resistance Estimation Value R\_h}) < (\text{Internal Resistance True Value Rtr}) \ ... \ (8)$$

(Open Circuit Voltage in Case of Tin < Ttr)

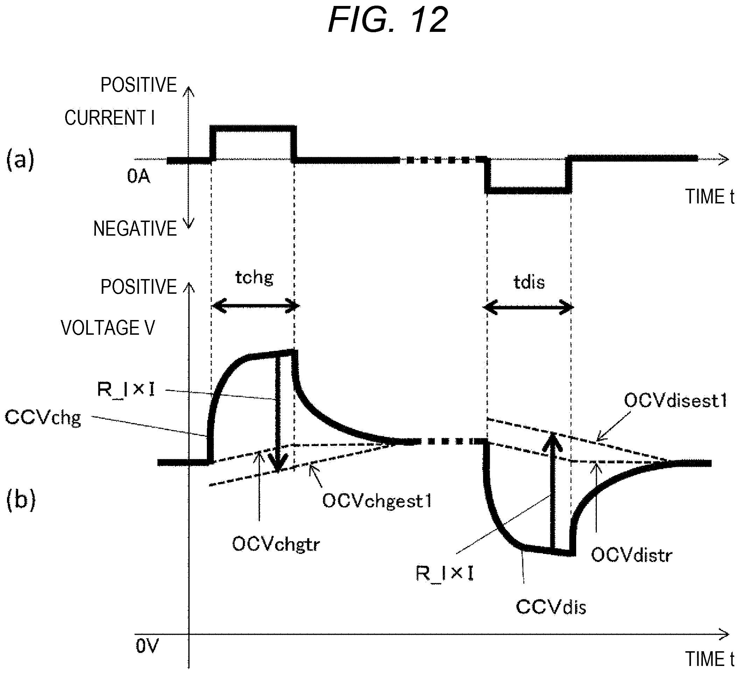

First, an open-circuit voltage estimation value in a case where the input temperature Tin is Tin_l (< Ttr) will be described using FIG. 12. FIG. 12(a) is a diagram illustrating a current value at the time of charging/discharging. FIG. 12(b) is a diagram illustrating a behavior of the closed-circuit voltage CCV at the time of charging/discharging. As illustrated in Expression (2), the open-circuit voltage OCV can be calculated by subtracting the I·R drop and the polarization voltage Vp from the measured closed-circuit voltage CCV. However, the polarization voltage Vp is not influenced by the change of the internal resistance caused by temperature, and thus will be omitted herein.
A closed-circuit voltage CCVchg at the time of the charging is increased by the starting of the charging. At this time, an open-circuit voltage estimation value OCVchgest1 during a charging period tchg is obtained by Expression (9). In addition, an open-circuit voltage estimation value OCVdisest1 during a discharging period tdis is obtained by Expression (10). Further, as described above, the polarization voltage Vp is omitted.

$$OCVchgest1 = OCVchg - R\_l \times I \ ... \ (9)$$

$$OCVdisest1 = OCVdis - R\_l \times I \ ... \ (10)$$

As illustrated in Expression (7), the internal resistance estimation value R_l is larger than the internal resistance true value Rtr. The magnitude relation of the following Expression (11) is satisfied between the true value OCVchgtr of the open-circuit voltage and the open-circuit voltage estimation value OCVchgest1. On the other hand, I < 0 is satisfied at the time of the discharging as illustrated in FIG. 12(a). Therefore, (-R_l × I) > (-Rtr × I) > 0 is satisfied. The magnitude relation of the following Expression (12) is satisfied between the true value OCVdistr of the open-circuit voltage and the open-circuit voltage estimation value OCVdisest1.

$$OCVchgest1 < OCVchgtr \ ... \ (11)$$

$$OCVchgest1 > OCVchgtr \ ... \ (12)$$

(Open-circuit Voltage in Case of Tin > Ttr)

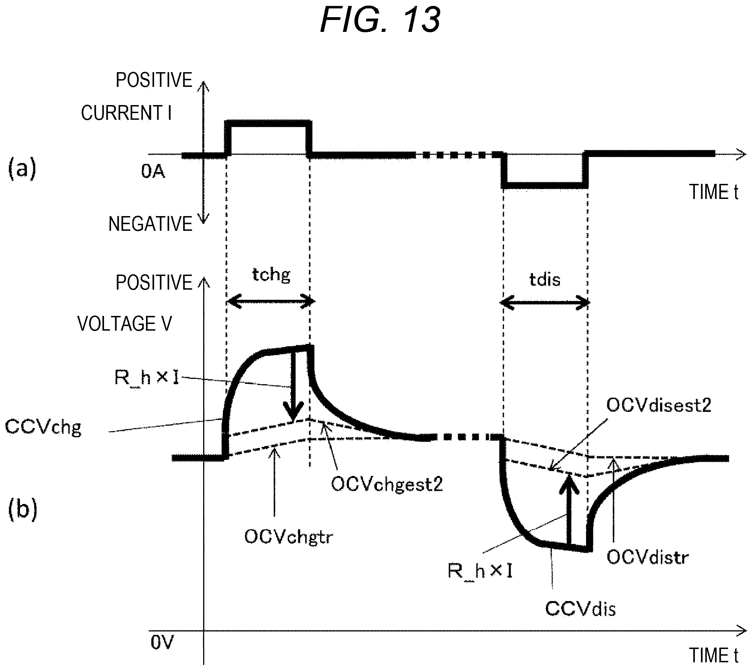

Next, a case where the input temperature Tin is Tin_h (> Ttr) will be described using FIG. 13. FIG. 13(a) is a diagram illustrating a current value at the time of the charging/discharging. FIG. 13(b) is a diagram for describing a behavior of the closed-circuit voltage CCV at the time of the charging/discharging. The closed-circuit voltage CCVchg is increased by the starting of the charging. At this time, an open-circuit voltage estimation value OCVchgest2 during the charging period tchg is obtained by the following Expression (13). In addition, an open-circuit voltage estimation value OCVdisest2 during the discharging period tdis is obtained by the following Expression (14).

$$OCVchgest2 = CCVchg - R\_h \times I \ ... \ (13)$$

$$OCVdisest2 = CCVdis - R\_h \times I \ ... \ (14)$$

As illustrated in Expression (8), the internal resistance estimation value R_h is smaller than the internal resistance true value Rtr. The magnitude relation of the following Expression (15) is satisfied between the true value OCVchgtr of the open-circuit voltage and the open-circuit voltage estimation value OCVchgest2. On the other hand, I < 0 is satisfied at the time of the discharging as illustrated in FIG. 13(a). Therefore, (-Rtr × I) > (-R_h × I) > 0 is satisfied. The magnitude relation of the following Expression (16) is satisfied between the true value OCVdistr of the open-circuit voltage and the open-circuit voltage estimation value OCVdisest2.

$$OCVchgtr < OCVchgest2 \ ... \ (15)$$

$$OCVdistr > OCVdisest2 \ ... \ (16)$$

The relation illustrated in FIG. 4 is satisfied between the open-circuit voltage OCV and the state of charge SOC. Therefore, in a case where the relation described above is satisfied between the estimation value and the true value of the open-circuit voltage OCV, it can be seen that the relations of the following Expressions (17) to (20) are satisfied between the estimation value and the true value of the state of charge SOC. Herein, the estimation value of the state of charge SOC obtained during the charging is represented as SOCchgest, and the estimation value obtained during the discharging is represented as SOCdisest. With this regard, the SOC true value during the charging and the discharging in the case of Tin < Ttr is represented as SOCchgtr1 and SOCdistr1. The SOC true value during the charging and the discharging in the case of Tin > Ttr is represented as SOCchgtr2 and SOCdistr2.

$$(Case \ of \ Tin < Ttr)$$

$$SOCchgest < SOCchgtr1 \ ... \ (17)$$

$$SOCdisest > SOCdistr1 \ ... \ (18)$$

(Case of Tin > Ttr)

$$SOCchgest > SOCchgtr2 \ldots (19)$$

$$SOCchgest < SOCdistr2 \ldots (20)$$

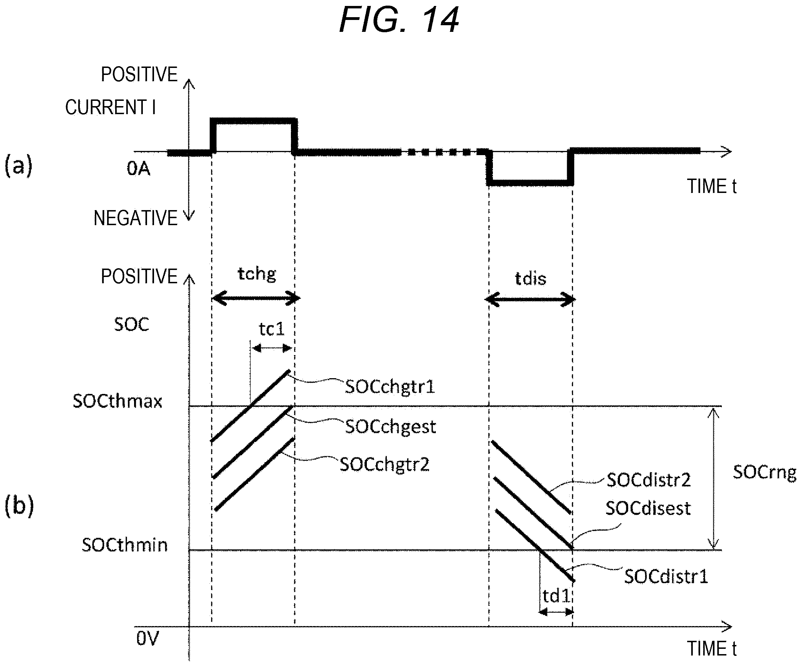

FIG. 14 is a diagram for describing a relation between SOCchgest, SOCchgtr1, and SOCchgtr2, and a relation between SOCdisest, SOCdistr1, and SOCdistr2. FIG. 14(a) is a diagram illustrating a transition of the charging/discharging current. FIG. 14(b) is a diagram illustrating a relation between the SOC estimation value and the SOC true value during the charging and the discharging. In the SOC true value, an SOC use range SOCrng (hereinafter, simply referred to as range) to be obtained is determined from a viewpoint of keeping the battery performance. In an SOC control, it is required that the SOC true value falls within the range SOCrng.

Referring to the charging period tchg of FIG. 14, an estimation value SOCchgest of the state of charge SOC is increased with time. At this time, the true value SOCchgtr1 in the case of Tin < Ttr always becomes a value larger than the estimation value SOCchgest. Therefore, in a period tc1, the true value SOCchgtr1 exceeds an upper limit SOCthmax of the range SOCrng even though the estimation value SOCchgest falls within the range SOCrng. In addition, in the discharging period tdis in which an estimation value SOCdisest is reduced, a true value SOCdistr1 in the case of Tin < Ttr is always smaller than the estimation value SOCdisest. Therefore, in a period td1, the true value SOCdistr1 is lower than a lower limit SOCthmin of the range SOCrng even though the estimation value SOCdisest falls within the range SOCrng.

In this way, in a case where the input temperature Tin is lower than the temperature true value Ttr (in the case of Tin < Ttr), the SOC true value may be deviated from the SOC use range. On the other hand, in a case where the input temperature Tin is higher than the temperature true value Ttr (in the case of Tin > Ttr), the true value SOCchgtr2 and SOCdistr2 always fall within the range SOCrng as long as the estimation values SOCchgest and SOCdisest during the charging/discharging are within the range SOCrng.

In this embodiment, in a case where the battery temperature (the second mode temperature) Tmode2 which is an average temperature of the temperatures T1 to T3 is equal to or more than the predetermined temperature Tth1 as the process of FIG. 9 or 15 described above, the battery temperature Tmode2 is employed for the input temperature Tin. In this case, the internal resistance R can be estimated with a high accuracy. Therefore, the estimation error of the state of charge SOCv calculated by the SOCv calculation unit 151 is also reduced, and the difference between the SOC estimation value and the true value is significantly reduced. As a result, the SOC true value is not likely to be significantly deviated from the range SOCrng of FIG. 14(b).

On the other hand, in a case where the battery temperature Tmode2 is lower than the predetermined temperature Tth1, the temperature T4 (= Tmode1) obtained, as a high temperature in the battery pack 110, by the heat transfer member 600 is employed for the input temperature Tin (see FIG. 10). In this case, the temperature T4 (= Tmode1) is separated from the battery temperature Tmode2 which is an average temperature. Therefore, the occurrence of the SOC estimation error is not avoidable. However, by setting Tin = T4, the input temperature Tin satisfies Tin > Ttr with respect to the true value Ttr. As a result, as described in FIG. 14, it is realized that the true values (SOCchgtr2 and SOCdistr2) of the state of charge SOC are controlled to fall within the required range SOCrng. With this configuration, it is possible to perform the control to suppress the degradation of the battery performances of the battery pack 110, the cell group 112, and the cell 111 caused by the deviation from the SOC use range.

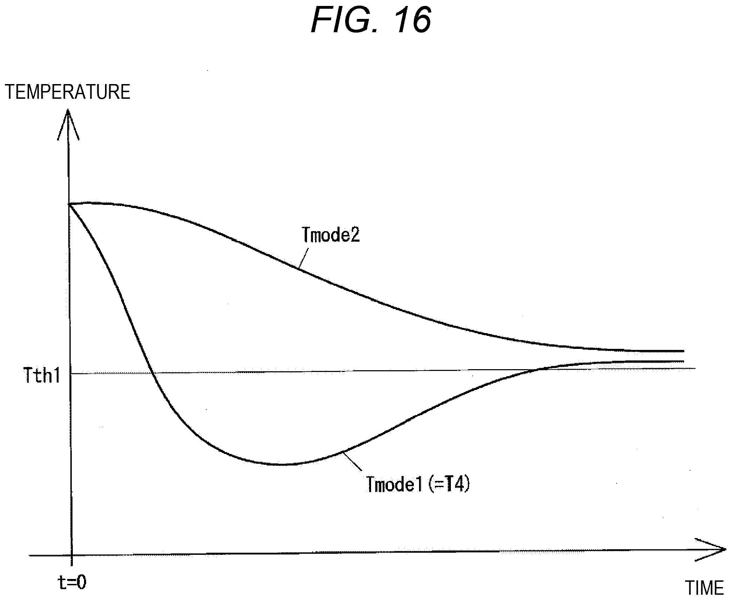

Further, in the case of a cooling mode where the battery temperature is overheated and cooled down by the heat transfer member 600, the first mode temperature Tmode1 which is the temperature T4 of the heat transfer member 600 and the second mode temperature Tmode2 which is an average temperature of the battery show the time transition as illustrated in FIG. 16. In this case, the control is performed so as not to cool down the battery excessively. The second mode temperature Tmode2 transitions at a temperature higher than the predetermined temperature Tth1. Therefore, in the case of the cooling mode, it is determined as NO in Step S15 of FIG. 15, and the control is performed to satisfy the input temperature Tin = Tmode2. In other words, the switching operation described in this embodiment operates without a defect even in the cooling mode.

- Second Embodiment -

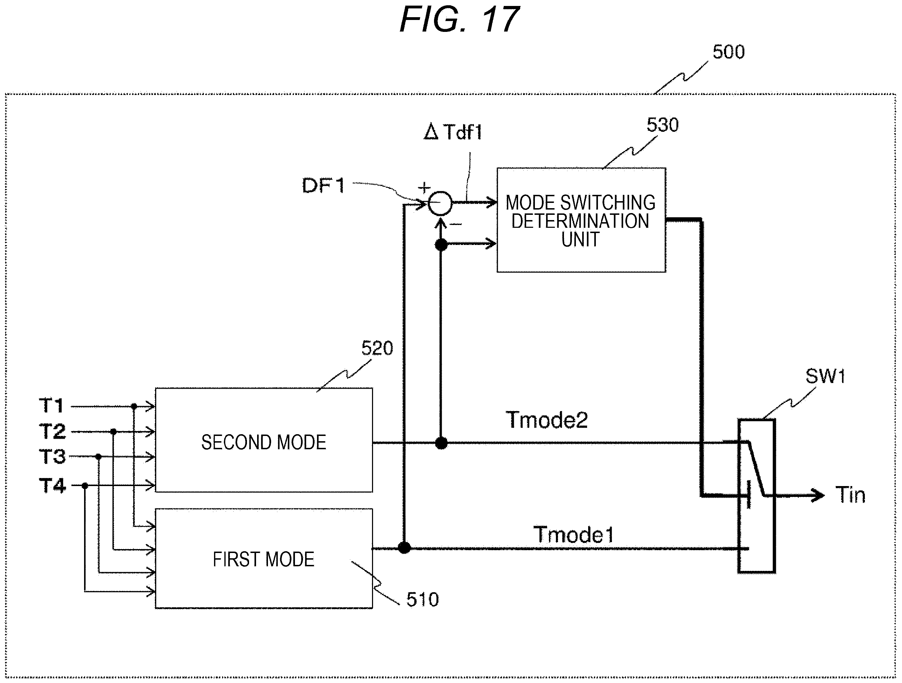

FIG. 17 is a block diagram of the temperature selection unit 500 according to a second embodiment. The temperature selection unit 500 includes the first mode calculation unit 510, the second mode calculation unit 520, the mode switching determination unit 530, the switch SW1, and a subtractor DF1. The temperatures T1 to T4 acquired as the temperatures of the battery pack 110 are input to the temperature selection unit 500. The temperatures T1 to T4 may be values from the temperature sensor which is not directly attached to the battery pack 110 as long as the temperature sensor is attached to acquire the temperature of the battery pack 110. Further, the following description will be made on an assumption that the heat transfer member 600 is not provided. Of course, the heat transfer member 600 may be provided. The temperatures T1 to T4 may include the temperature of the heat transfer member 600 as needed.

The temperatures T1 to T4 are input to the first mode calculation unit 510 and the second mode calculation unit 520. Further, the number of temperatures input to the first mode calculation unit 510 and the second mode calculation unit 520 is not limited to four. In addition, a combination of temperatures input to the first mode calculation unit 510 and the second mode calculation unit 520 may be different from that in the case of FIG. 17. The first mode calculation unit 510 outputs the highest temperature among the input temperatures T1 to T4 as the first mode temperature Tmode1. The second mode calculation unit 520 outputs an average value (average temperature) of the input temperatures T1 to T4 as the second mode temperature Tmode2.

The subtractor DF1 calculates a difference $\Delta$Tdf1 between the first mode temperature Tmode1 and the second mode temperature Tmode2 which are input. The difference $\Delta$Tdf1 is represented as the following Expression (21).

$$\Delta\mathrm{Tdf1} = \mathrm{Tmode1} - \mathrm{Tmode2} \dots (21)$$

The first mode temperature Tmode1 output from the first mode calculation unit 510 and the difference $\Delta$Tdf1 calculated by the subtractor DF1 are input to the mode switching determination unit 530. The mode switching determination unit 530 switches the switch SW1 on the basis of the first mode temperature Tmode1 and the difference $\Delta$Tdf1.

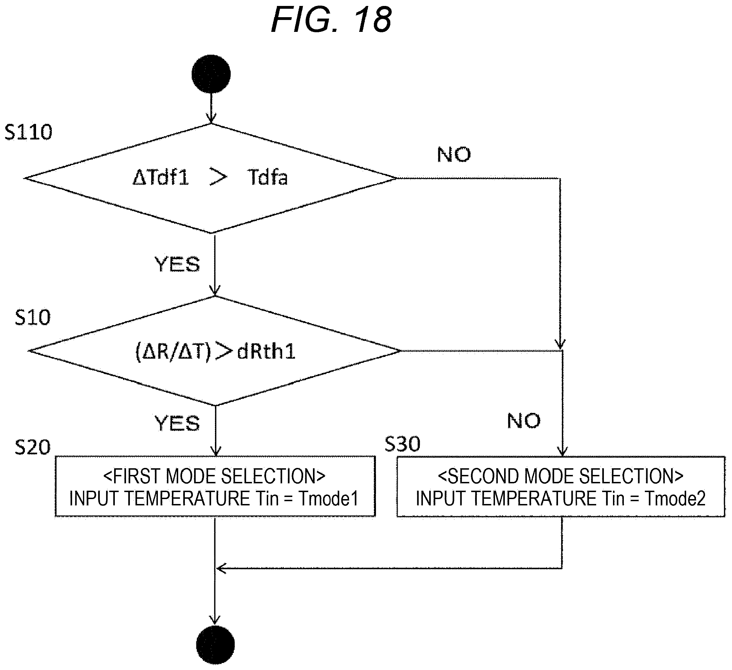

FIG. 18 is a flowchart illustrating a processing flow of the mode switching determination unit 530. In Step S110, it is determined whether the difference $\Delta$Tdf1 between the maximum temperature and the average temperature becomes larger than a predetermined value Tdfa, that is, whether the temperature distribution becomes large in the battery pack 110. If it is determined in Step S110 that $\Delta$Tdf1 > Tdfa is satisfied, the process proceeds to Step S10. If it is determined that $\Delta$Tdf1 $\leq$ Tdfa is satisfied, the process proceeds to Step S30. In the case of $\Delta$Tdf1 $\leq$ Tdfa, the temperature distribution in the battery pack 110 is small. In Step S30, the switch SW1 is switched such that the second mode temperature Tmode2 (the average temperature) is output as the input temperature Tin.

On the other hand, in a case where the process proceeds from Step S110 to Step S10, that is, in a case where the temperature distribution becomes large in the battery pack 110, it is determined whether the change rate ($\Delta$R/$\Delta$T) of the internal resistance R in the second mode temperature Tmode2 is larger than the predetermined value dRth1, similarly to the case of the first embodiment. Then, in the case of ($\Delta$R/$\Delta$T) > dRth1, the process proceeds to Step S20. The switch SW1 is switched to output the first mode temperature Tmode1 (the maximum temperature) as the input temperature Tin. In the case of ($\Delta$R/$\Delta$T) $\leq$ dRth1, the process proceeds to Step S30. The switch SW1 is switched to output the second mode temperature Tmode2 (the average temperature) as the input temperature Tin.

As described above, in the second embodiment, only in a case where the temperature difference in the battery pack 110 becomes large, the average temperature (the second mode temperature Tmode2) and the high temperature (the first mode temperature Tmode1) is switched similarly to the first embodiment. For example, in a case where the warming is performed, the difference $\Delta$Tdf1 between the maximum temperature and the average temperature becomes generally large. It is determined as YES in Step S110, and the process proceeds to Step S10.

On the other hand, in a case where the warming or the cooling is not performed and the temperature difference in the battery pack 110 is small, the battery temperature Tmode2 which is the average temperature becomes comparatively low. In such a case, the high temperature Tmode1 is to be employed as the input temperature Tin originally. However, if a separate high temperature is employed, the accuracy of the SOCv calculation is worse. Therefore, as illustrated in FIG. 18, the process proceeds from Step S110 to Step S30, and the battery temperature Tmode2 which is the average temperature is preferably output as the input temperature Tin.

- Third Embodiment -

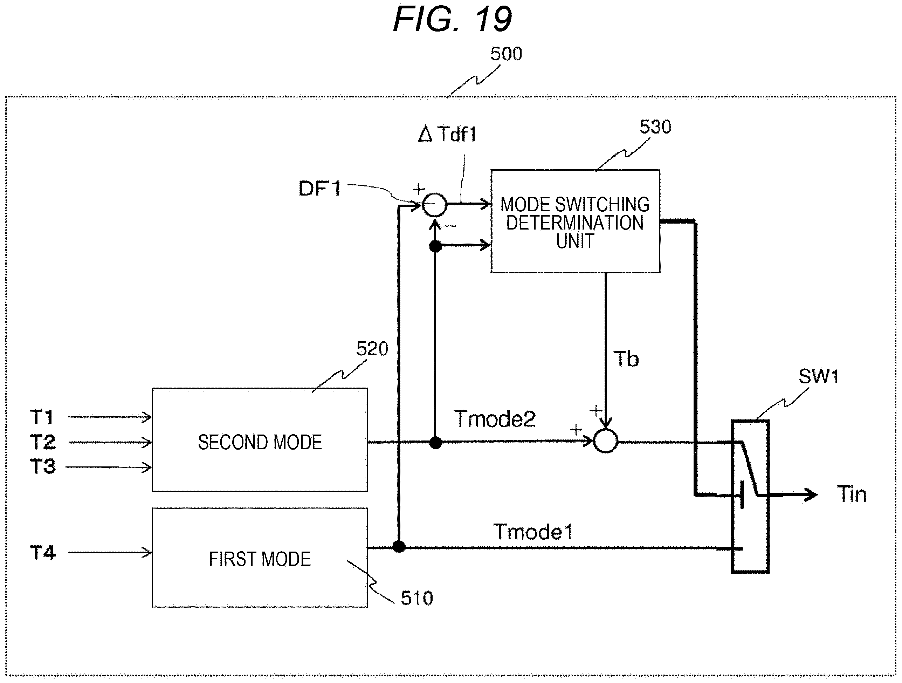

FIG. 19 is a block diagram of the temperature selection unit 500 according to a third embodiment. Similarly to the case of the first embodiment, the first mode calculation unit 510 outputs the input high temperature T4 as the first mode temperature Tmode1. The second mode calculation unit 520 outputs the average temperature of the input temperatures T1 to T3 as the second mode temperature Tmode2. Similarly to the case of the first embodiment, the second mode temperature is called the battery temperature Tmode2. The first mode temperature Tmode1 and the battery temperature Tmode2 are input to the subtractor DF1. The difference $\Delta$Tdf1 (= Tmode1 - Tmode2) is output from the subtractor DF1.

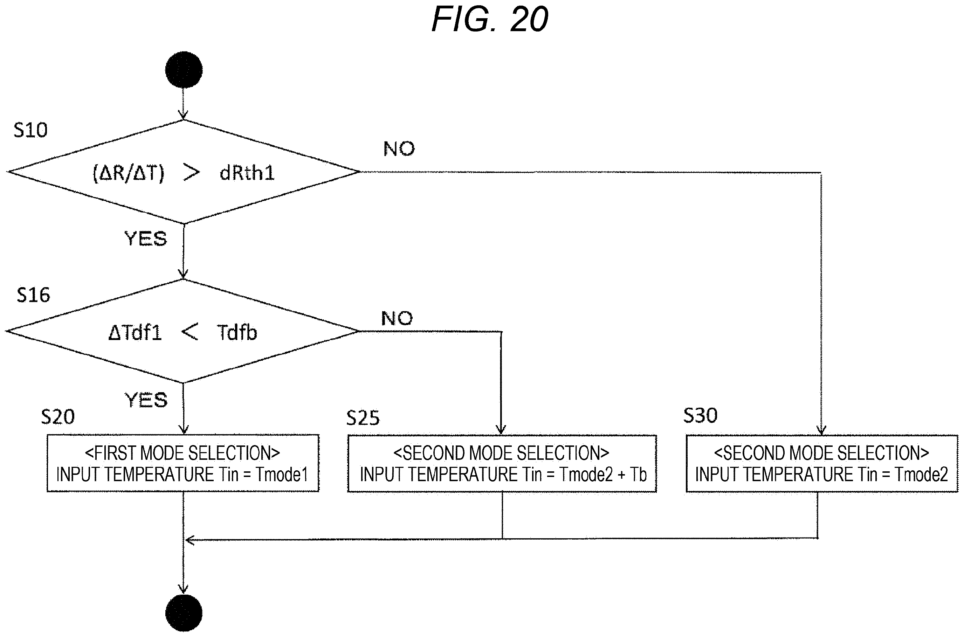

FIG. 20 is a flowchart illustrating a processing flow of the mode switching determination unit 530 according to the third embodiment. Similarly to the case of the first embodiment, it is determined in Step S10 whether ($\Delta$R/$\Delta$T) > dRth1 is satisfied. In a case where ($\Delta$R/$\Delta$T) > dRth1 is satisfied, the process proceeds to Step S16. In a case where

($\Delta R/\Delta T$) > dRth1 is satisfied, the process proceeds to Step S30. In a case where the process proceeds to Step S30, the switch SW1 is switched to output the battery temperature Tmode2 output from the second mode calculation unit 520 as the input temperature Tin.

On the other hand, in a case where the process proceeds to Step S16, the temperature difference $\Delta$Tdf1 and a predetermined value Tdfb are compared, and it is determined whether $\Delta$Tdf1 < Tdfb is satisfied. In a case where $\Delta$Tdf1 < Tdfb is satisfied, the process proceeds to Step S20. The switch SW1 is switched to output the first mode temperature Tmode1 as the input temperature Tin. On the contrary, in a case where $\Delta$Tdf1 < Tdfb is not satisfied, the process proceeds to Step S25, and Tmodo2 + Tb is output as the input temperature Tin. Herein, an example of a predetermined value Tb includes the predetermined value Tdfb which is a determination reference of the temperature difference $\Delta$Tdf1.

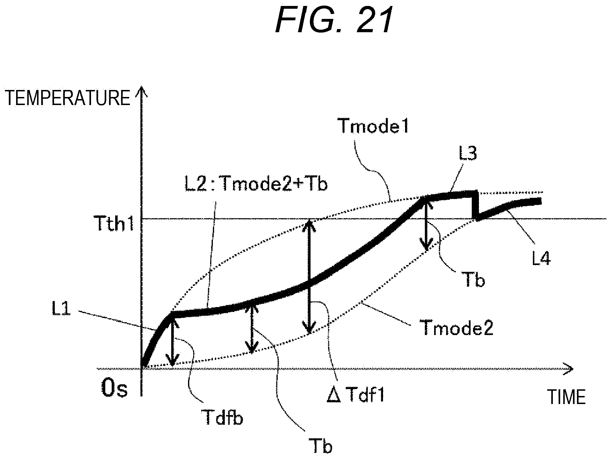

FIG. 21 is a graph illustrating the time transition of the input temperature Tin according to the third embodiment. In FIG. 21, a case where Tb is set as Tb = Tdfb is illustrated. When the warming starts, the temperature distribution occurs in the battery pack 110, and the temperature difference $\Delta$Tdf1 between the first mode temperature Tmode1 and the battery temperature Tmode2 begins to increase. Until the battery temperature Tmode2 becomes equal to or more than the predetermined temperature Tth1 where ($\Delta R/\Delta T$) $\leq$ dRth1 is satisfied, it is determined as YES in Step S10, and the process of Step S16 is performed. Immediately after the warming starts, $\Delta$Tdf1 < Tdfb is satisfied. Therefore, the process proceeds from Step S16 to Step S20. As a result, the input temperature Tin is set to satisfy Tin = Tmode1, and transitions along a curve L1.

Thereafter, when the temperature difference $\Delta$Tdf1 becomes large, and $\Delta$Tdf1 $\geq$ Tdfb is satisfied, it is determined as NO in Step S16, and Step S25 is performed. As a result, the input temperature Tin is set to satisfy Tin = Tmode2 + Tb, and transitions along a curve L2 from the curve L1. The input temperature transitions to increase similarly to the battery temperature Tmode2. Thereafter, when the temperature difference $\Delta$Tdf1 between the first mode temperature Tmode1 and the battery temperature Tmode2 becomes small to satisfy $\Delta$Tdf1 < Tdfb, the process proceeds again from Step S16 to Step S20. As a result, the input temperature Tin is set to satisfy Tin = Tmode1, and transitions from the curve L2 to a curve L3 which is matched to the line of Tmode1.

Thereafter, when the battery temperature Tmode2 is further increased to become equal to or more than the predetermined temperature Tth1 at which ($\Delta R/\Delta T$) $\leq$ dRth1 is satisfied, it is determined as NO in Step S10, and Step S30 is performed. As a result, the input temperature Tin is set to satisfy Tin = Tmode2, and the input temperature Tin transitions from the curve L3 to a curve L4 which is matched to the line of Tmode2.

As described above, in the third embodiment, the input temperature Tin is changed as the curve L1 which is matched to the line of Tmode1 when the warming starts. However, in a case where the temperature difference $\Delta$Tdf1 in the battery pack 110 becomes larger than the predetermined value Tdfb, the input temperature Tin is limited to Tmode2 + Tb. With such a control, it is possible to suppress that the temperature Tmode1 on the high temperature side is employed as the input temperature Tin in a sensitive reaction to a situation that the battery pack 110 is locally and steeply heated so as to be partially extremely heated, and most of the portion in the battery pack 110 is heated low.

In addition, by setting Tb to be equal to Tdfb, a steep change does not occur in the input temperature Tin at the time of transition from the curve L1 to the curve L2 of FIG. 21 and at the time of transition from the curve L2 to the curve L3. As a result, it is possible to suppress the degradation in the accuracy of the SOCv calculation caused by a steep change of the internal resistance R.

- Fourth Embodiment -

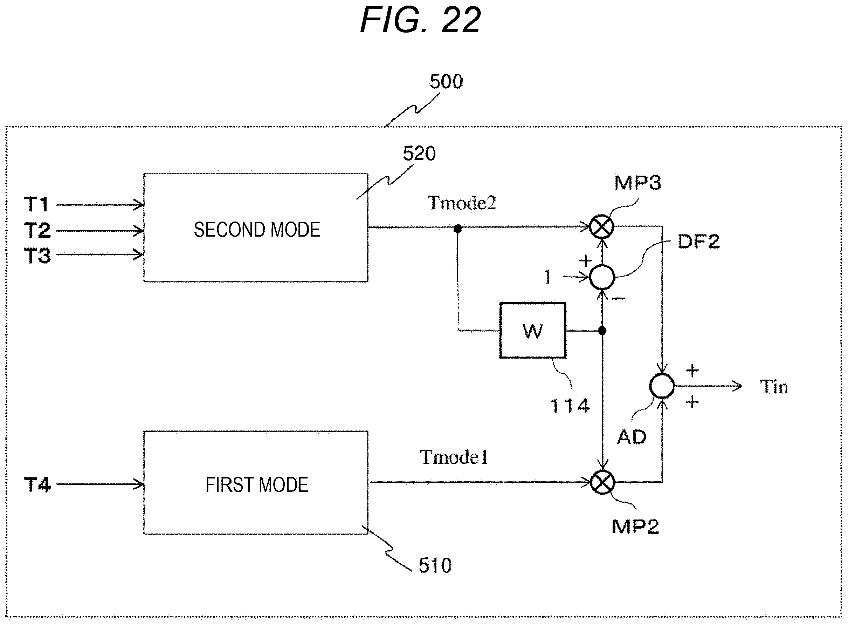

FIG. 22 is a block diagram of the temperature selection unit 500 according to a fourth embodiment. In the fourth embodiment, the output Tmode1 of the first mode calculation unit 510 and the output Tmode2 of the second mode calculation unit 520 are combined using a weight W. The combination is used as the input temperature Tin. Even in this embodiment, the first mode calculation unit 510 outputs the input high temperature T4 as the first mode temperature Tmode1. In addition, the second mode calculation unit 520 outputs the average temperature of the input temperatures T1 to T3 as the battery temperature Tmode2.

The weight W ($0 \leq W \leq 1$) generated by a W generator 114 is input to a multiplier MP2 and a subtractor DF2. The subtractor DF2 subtracts the weight W from 1, and inputs the subtraction result (1 - W) to a multiplier MP3. The first mode temperature Tmode1 output from the first mode calculation unit 510 is multiplied to the weight W in the multiplier MP2, and W $\times$ Tmode1 is obtained. The battery temperature Tmode2 output from the second mode calculation unit 520 is multiplied to (1 - W) in the multiplier MP3, and (1 - W) $\times$ Tmode2 is obtained. W $\times$ Tmode1 and (1 - W) $\times$ Tmode2 of the calculation result are added by an adder AD, and the addition result is output as the input temperature Tin. In other words, the input temperature Tin is represented as the following Expression (22). As illustrated in Expression (22), the input temperature Tin is obtained by combining the first mode temperature Tmode1 and the battery temperature Tmode2, and a degree of the combination can be adjusted by the weight W.

$$Tin = W \times Tmode1 + (1 - W) \times Tmode2 \dots (22)$$

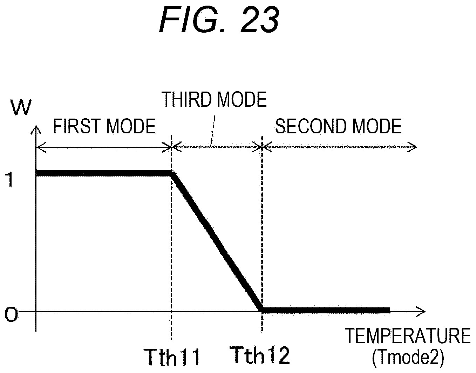

FIG. 23 is a diagram illustrating an example of a weight W which is generated by the W generator 114. The horizontal axis represents the battery temperature Tmode2 which is the average temperature of the battery pack 110, and the vertical axis represents the weight W. The W generator 114 generates the weight W as illustrated in FIG. 23 according to the value of the battery temperature Tmode2. Tth11 and Tth12 are temperature thresholds which are timings to change a change mode of the weight W. Herein, Tth11 is called a low reference temperature, and Tth12 is called a high reference temperature. In the case of Tmode2 ≤ Tth11, Tin = Tmode1 is set in a first mode (W = 1). In the case of Tmode2 ≥ Tth12, Tin = Tmode2 is set in a second mode (W = 0). In the case of Tth11 < Tmode2 < Tth12, the weight W is set to 0 < W < 1 in a third mode. In the third mode, the weight W is set such that W is converged to 1 as the battery temperature Tmode2 approaches the low reference temperature Tth11, and W is converged to 0 as the battery temperature Tmode2 approaches to the high reference temperature Tth12. In the example illustrated in FIG. 22, W is linearly reduced from 1 to 0 as the battery temperature Tmode2 is increased in the third mode.

In a case where W takes only 1 or 0, the input temperature Tin is steeply switched between Tmode1 and Tmode2 when W is switched between 1 and 0. Therefore, there is a concern that the accuracy of the SOCv estimation value is degraded at the moment that the weight W is switched. Thus, in this embodiment, the third mode is provided in which the weight W is changed in 0 < W < 1 between the first mode and the second mode.

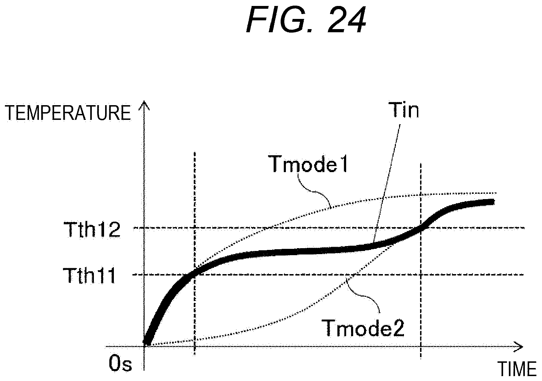

FIG. 24 is a graph illustrating the time transition of the input temperature Tin at the time of the warming. When the warming starts, the battery temperature Tmode2 which is the average temperature of the battery pack 110 is in the state of Tmode2 ≤ Tth11. The weight W is set to 1, and the input temperature Tin is set to the first mode temperature Tmode1 (Tin = Tmode1).

Next, the description will be made in consideration of a case where the battery temperature Tmode2 satisfies Tth11 < Tmode2 < Tth12. At this time, the input temperature Tin is set to Tin = W × Tmode1 + (1 - W) × Tmode2. Since the weight W is changed in 0 < W < 1, the input temperature Tin satisfies the following Expressions (23) and (24). Further, in a case where the battery pack 110 is sufficiently heated by the warming, the battery temperature Tmode2 is increased to satisfy Tmode2 > Tth12. Therefore, W = 0 is output from the W generator 114, and the input temperature Tin becomes Tin = Tmode2.

$$Tmode1 > Tin > Tmode2 \dots (23)$$

$$Tth11 < Tin < Tth12 \dots (24)$$

In this way, in a case where the input temperature Tin which switches the weight W between 0 and 1 is switched between Tmode1 and Tmode2, the third mode is introduced as described above, so that the temperature can be smoothly switched. As a result, it is possible to prevent an estimation error of the internal resistance R from occurring which is generated at the time of switching the modes of the input temperature Tin. It is possible to suppress the degradation of the SOCv estimation accuracy.

- Fifth Embodiment -

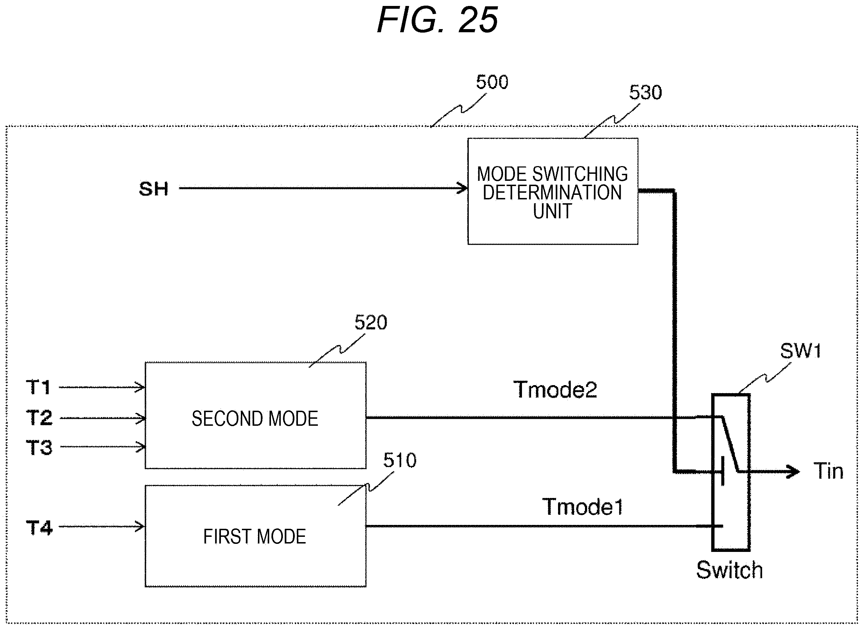

FIG. 25 is a block diagram of the temperature selection unit 500 according to a fifth embodiment. In the first embodiment, the second mode temperature (the battery temperature) Tmode2 which is the average temperature of the battery pack 110 and the magnitude relation of the predetermined temperature Tth1 are compared to determine whether the first mode temperature Tmode1 or the second mode temperature (the battery temperature) Tmode2 is used as the input temperature Tin. In this embodiment, for example, a warming state signal SH is acquired from the host vehicle control unit 200. The mode switching determination unit 530 switches the switch SW1 on the basis of the warming state signal SH.

The mode switching determination unit 530 switches the switch SW1 on the basis of the input warming state signal SH. Similarly to the first embodiment, the first mode calculation unit 510 outputs the input high temperature T4 as the first mode temperature Tmode1. The second mode calculation unit 520 outputs the average temperature of the input temperatures T1 to T3 as the second mode temperature (the battery temperature) Tmode2.

In a case where the warming state signal SH is in a state indicating the warming, the mode switching determination unit 530 switches the switch SW1 to output the first mode temperature Tmode1 as the input temperature Tin. On the contrary, when the warming state signal SH is in a state not indicating the warming, the mode switching determination unit 530 switches the switch SW1 to output the second mode temperature (the battery temperature) Tmode2 as the input temperature Tin.

Further, in the above example, the warming state signal SH has been input from the vehicle control unit 200 which is provided on the outside of the battery system 100. However, a function of outputting the warming state signal SH may be provided in any place outside or inside the battery system 100. The warming has been determined on the basis of one warming state signal SH, but a plurality of signals may be combined to determine the warming.

According to the above embodiment, the following operational effects are obtained.

(C1) The battery state estimation unit 150 which is the battery control device includes the SOCv calculation unit 151 which calculates the state of charge SOCv on the basis of the temperature T and the voltage value V of the battery and the SOCi calculation unit 152 which calculates the state of charge SOCi on the basis of the current value I of the battery as illustrated in FIG. 2, and controls the charging/discharging of the battery on the basis of the state of charge SOC based on the state of charge SOCv and the state of charge SOCi.

Then, the temperature T includes the plurality of temperatures T1 to T4 which are measured at plural positions of the battery as illustrated in FIG. 6. The SOCv calculation unit 151 switches the first mode in which the SOC calculation is performed on the basis of the first mode temperature Tmode1 on the high temperature side of the battery and the second mode in which the SOC calculation is performed on the basis of the second mode temperature Tmode2 on the low temperature side of the battery, on the basis of the amplitude of the second mode temperature Tmode2. In this way, the first mode in which the SOC calculation is applied in a case where the estimation error of the internal resistance is large and the second mode in which the SOC calculation is applied in a case where the estimation error of the internal resistance is small are set. The modes are switched according to the magnitude of the battery, that is, a degree of the estimation error of the internal resistance.

With this configuration, it is possible to prevent that the SOC true value with respect to the SOC estimation value illustrated in FIG. 14(b) is deviated from the range SOCrng like the true values SOCCchgtr1 and SOCdistr1 of FIG. 14(b). The SOC true value is controlled to fall into the range SOCrng like the true values SOCCchgtr2 and SOCdistr2. As a result, it is possible to prevent the degradation of the battery performances of the battery pack 110, the cell group 112, and the cell 111 caused by the deviation from the SOC use range.

(C2) As a method of switching on the basis of the magnitude of the second mode temperature Tmode2, for example, a threshold temperature (Tth1) of the second mode temperature Tmode2 corresponding to a threshold (dRth1) is set on the basis of the change rate $\Delta R/\Delta T$ of the internal resistance of the battery. As described in FIG. 15, in a case where the second mode temperature Tmode2 of the lower temperature side is lower than the threshold temperature (Tth1) related to the SOC calculation accuracy, the mode is switched to the first mode. In a case where the second mode temperature Tmode2 is equal to or more than the threshold temperature (Tth1), the mode is switched to the second mode. In addition, as illustrated in FIG. 9, the mode may be switched according to whether the change rate $\Delta R/\Delta T$ of the internal resistance is larger than the threshold (dRth1).

(C3) In addition, in a case where it is known in advance that the temperature is to be increased by the warming like the heat transfer member 600 of FIG. 6, the temperature T4 of the heat transfer member 600 transferring heat with the battery is set to the first mode temperature Tmode1 on the high temperature side. Therefore, the process of selecting the first mode temperature Tmode1 on the high temperature side from among the plurality of temperatures can be omitted. As a medium of transferring heat, a fluid configured such that the battery is sunk in a liquid to be warmed up may be employed as well as the heat transfer member 600 which is provided to abut on the battery as illustrated in FIG. 6.

(C4) Further, in a case where a difference between the first mode temperature Tmode1 and the second mode temperature Tmode2 is smaller than a predetermined value, for example, in a case where the warming is not performed, the temperature difference depending on the position of the battery pack 110 becomes small. In such a case, it is desirable to output the second mode temperature Tmode2 as the input temperature Tin.

(C5) In addition, as illustrated in FIG. 20, in the case of $(\Delta R/\Delta T) > dRth1$, that is, in a case where the second mode temperature Tmode2 is lower than the threshold temperature (Tth1) related to the SOC calculation accuracy, and in a case where the difference $\Delta Tdf1$ between the first mode temperature Tmode1 and the second mode temperature Tmode2 is smaller than the predetermined value Tdfb, the SOC calculation is performed on the basis of the first mode temperature Tmode1. In a case where the difference $\Delta Tdf1$ is equal to or more than the predetermined value Tdfb, the SOC calculation is performed on the basis of the temperature obtained by adding a correction amount (Tb) equal to or less the predetermined value Tdfb to the second mode temperature Tmode2. In FIG. 20, the correction amount (Tb) is set to a value equal to the predetermined value Tdfb, so that the input temperature Tin is set to Tmode2 + Tb. Herein, Tmode2 + Tb becomes Tmode1 - ($\Delta Tdf1$ - Tb) when being expressed using the first mode temperature Tmode1.

With such a control, it is possible to suppress that the first mode temperature Tmode1 on the high temperature side is employed as the input temperature Tin in a sensitive reaction to a situation that the battery pack 110 is locally and steeply heated so as to be partially extremely heated, and most of the portion in the battery pack 110 is heated low.

(C6) In addition, as illustrated in FIGS. 23 and 24, in a case where the second mode temperature Tmode2 is larger than a first threshold (Tth11) but is smaller than a second threshold (Tth12), the SOC calculation is performed on the basis of the temperature Tin which is calculated by the equation "W $\times$ (Tmode1) + (1 - W) $\times$ (Tmode2)" using the

weight W. When the SOC calculation is performed on the basis of the temperature Tin, the weight W may be reduced from "1" to "0" as the temperature of the second mode temperature Tmode2 rises. The temperature can be switched seamlessly by setting the temperature Tin used for the SOC calculation. It is possible to prevent the estimation error of the internal resistance R which occurs at the time of switching the mode of the input temperature Tin. The degradation of the SOCv estimation accuracy can be suppressed.

(C7) As illustrated in FIG. 25, in a case where the warming state signal SH indicating warming state that the heat transfer member 600 rises in temperature is input to the temperature selection unit 500, the mode may be switched to the first mode when the warming state signal SH is received instead of performing the switching according to the magnitude of the second mode temperature Tmode2, or may be switched to the second mode at the time of receiving no warming state signal SH.

(C8) As the second mode temperature Tmode2, an average value of the plurality of temperatures or an average value obtained by subtracting the first mode temperature Tmode1 from the plurality of temperatures is employed. For example, as illustrated in FIG. 6, in a case where the temperature T4 is the heat transfer member 600 and there is a large difference from the temperature of the state of the battery pack 110 in the warming, it is preferred that the average temperature of the temperatures T1 to T3 be set to the second mode temperature Tmode2 except the temperature T4 as illustrated in FIG. 7.

Hitherto, various embodiments and modifications have been described, but the invention is not limited the contents thereof, and may be formed by combinations thereof. Other embodiments may also be included in the scope of the invention, which is defined by the appended claims.

Reference Signs List

| | |
|---|---|
| 100 | battery system |
| 110 | battery pack |
| 111 | cell |
| 114 | W generator |
| 120 | measurement unit |
| 121, 121a, 121b | cell control unit |
| 130 | current detection unit |
| 140 | voltage detection unit |
| 150 | battery state estimation unit |
| 151 | SOCv calculation unit |
| 152 | SOCi calculation unit |
| 153 | combination calculation unit |
| 180 | memory unit |
| 200 | vehicle control unit |
| 400 | inverter |
| 410 | motor generator |
| 510 | first mode calculation unit |
| 520 | second mode calculation unit |
| 530 | mode switching determination unit |
| 600 | heat transfer member |
| SH | warming state signal |
| SW1 | switch |
| Tmode1 | first mode temperature |
| Tmode2 | second mode temperature |

Claims

1.  A battery control device, comprising:

    a first state of charge, SOC, calculation unit (151) which is configured to calculate a first battery charging state (SOCv) on the basis of a temperature and a voltage value of a battery; and
    a second SOC calculation unit (152) which is configured to calculate a second battery charging state (SOCi) on the basis of a current value of the battery,

wherein the battery control device is configured to control charging/discharging of the battery on the basis of a third battery charging state (SOC) based on the first battery charging state (SOCv) and the second battery charging state (SOCi),

**characterized in that**

the temperature includes a plurality of temperatures measured at plural positions of the battery, and the first SOC calculation unit (151) is configured to switch

- a first mode in which an SOC calculation of the battery is performed on the basis of a first temperature on a high temperature side of the battery and
- a second mode in which the SOC calculation of the battery is performed on the basis of a second temperature on a low temperature side of the battery on the basis of a magnitude of the second temperature.

2. The battery control device according to claim 1, wherein

the battery control device is configured to switch to the first mode in a case where the second temperature is lower than a threshold temperature set on the basis of a change rate of an internal resistance of the battery, and the battery control device is configured to switch to the second mode in a case where the second temperature is equal to or more than the threshold temperature.

3. The battery control device according to claim 1 or 2, wherein the first temperature is a temperature of a medium which transfers heat with the battery.

4. The battery control device according to any one of claims 1 to 3, wherein

in a case where a difference between the first temperature and the second temperature is larger than a predetermined value, the first SOC calculation unit (151) is configured to perform switching on the basis of a magnitude of the second temperature, and

the battery control device is configured to switch to the second mode in a case where the difference is equal to or less than the predetermined value.

5. The battery control device according to claim 2, wherein

in a case where the second temperature is lower than the threshold temperature related to an SOC calculation accuracy,

the first SOC calculation unit (151) is configured to perform perform an SOC calculation of the battery on the basis of the first temperature in a case where a difference between the first temperature and the second temperature is smaller than a predetermined value, and

the first SOC calculation unit (151) is configured to perform the SOC calculation of the battery on the basis of a temperature obtained by adding a correction amount equal to or less than the predetermined value to the second temperature in a case where the difference is equal to or more than the predetermined value.

6. The battery control device according to claim 1, wherein the first SOC calculation unit (151) is configured to:

- switch the mode to the first mode in a case where the second temperature is equal to or less than a first threshold,
- switch the mode to the second mode in a case where the second temperature is equal to or more than a second threshold,
- perform an SOC calculation of the battery on the basis of a third temperature calculated by an equation "W $\times$ (first temperature) + (1 - W) $\times$ (second temperature)" using a weight W in a case where the second temperature is larger than the first threshold and smaller than the second threshold, and
- reduce the weight W from 1 to 0 as the second temperature rises when the SOC calculation is performed on the basis of the third temperature.

7. The battery control device according to claim 3,

wherein a warming state signal indicating a warming state where the medium rises in temperature is input, and the first SOC calculation unit (151) is configured to switch the mode to the first mode when the warming state signal is received instead of performing the switching according to the magnitude of the second temperature,

and to switch the mode to the second mode when no warming state signal is received.

8. The battery control device according to any one of claims 1 to 3,
wherein the second temperature is an average value of the plurality of temperatures or an average value of the plurality of temperatures except the first temperature.


**Patentansprüche**

1. Batteriesteuerungsvorrichtung, umfassend:

    eine erste Berechnungseinheit (151) zur Berechnung des Ladezustands SOC, die so konfiguriert ist, dass sie einen ersten Batterieladezustand (SOCv) auf der Grundlage einer Temperatur und eines Spannungswertes einer Batterie berechnet; und
    eine zweite SOC-Berechnungseinheit (152), die so konfiguriert ist, dass sie einen zweiten Batterieladezustand (SOCi) auf der Grundlage eines Stromwerts der Batterie berechnet,
    wobei die Batteriesteuerungsvorrichtung so konfiguriert ist, dass sie das Laden/Entladen der Batterie auf der Grundlage eines dritten Batterieladezustands (SOC) basierend auf dem ersten Batterieladezustand (SOCv) und dem zweiten Batterieladezustand (SOCi) steuert,

    **dadurch gekennzeichnet, dass**

    die Temperatur eine Vielzahl von Temperaturen umfasst, die an mehreren Positionen der Batterie gemessen werden, und
    die erste SOC-Berechnungseinheit (151) dazu ausgelegt ist, folgendermaßen zu schalten:

        - einen ersten Modus, in dem eine SOC-Berechnung der Batterie auf der Grundlage einer ersten Temperatur auf einer Hochtemperaturseite der Batterie durchgeführt wird, und
        - einen zweiten Modus, in dem die SOC-Berechnung der Batterie auf der Grundlage einer zweiten Temperatur auf einer Niedertemperaturseite der Batterie auf der Grundlage einer Größe der zweiten Temperatur durchgeführt wird.

2. Batteriesteuerungsvorrichtung nach Anspruch 1, wobei

    die Batteriesteuerungsvorrichtung so konfiguriert ist, dass sie in den ersten Modus umschaltet, wenn die zweite Temperatur niedriger ist als eine Schwellentemperatur, die auf der Grundlage einer Änderungsrate eines Innenwiderstands der Batterie festgelegt wird, und
    die Batteriesteuerungsvorrichtung so konfiguriert ist, dass sie in den zweiten Modus umschaltet, wenn die zweite Temperatur gleich oder höher als die Schwellentemperatur ist.

3. Batteriesteuerungsvorrichtung nach Anspruch 1 oder 2, wobei
die erste Temperatur eine Temperatur eines Mediums ist, das Wärme mit der Batterie überträgt.

4. Batteriesteuerungsvorrichtung nach einem der Ansprüche 1 bis 3, wobei

    in einem Fall, in dem eine Differenz zwischen der ersten Temperatur und der zweiten Temperatur größer als ein vorbestimmter Wert ist, die erste SOC-Berechnungseinheit (151) so konfiguriert ist, dass sie ein Umschalten auf der Grundlage einer Größe der zweiten Temperatur durchführt, und
    die Batteriesteuerungsvorrichtung so konfiguriert ist, dass sie in einem Fall, in dem die Differenz gleich oder kleiner als der vorbestimmte Wert ist, in den zweiten Modus schaltet.

5. Batteriesteuerungsvorrichtung nach Anspruch 2, wobei

    in einem Fall, in dem die zweite Temperatur niedriger ist als die Schwellentemperatur betreffend eine SOC-Berechnungsgenauigkeit,
    die erste SOC-Berechnungseinheit (151) dazu ausgelegt ist, in einem Fall, in dem eine Differenz zwischen der ersten Temperatur und der zweiten Temperatur kleiner als ein vorbestimmter Wert ist, eine SOC-Berechnung der Batterie auf der Grundlage der ersten Temperatur durchzuführen und

die erste SOC-Berechnungseinheit (151) dazu ausgelegt ist, in einem Fall, in dem die Differenz gleich oder größer als der vorbestimmte Wert ist, die SOC-Berechnung der Batterie auf der Grundlage einer Temperatur durchzuführen, die ermittelt wird durch Addieren eines Korrekturbetrags, der gleich oder kleiner als der vorbestimmte Wert ist, zu der zweiten Temperatur.

6. Batteriesteuerungsvorrichtung nach Anspruch 1,
wobei die erste SOC-Berechnungseinheit (151) dazu ausgelegt ist:

- den Modus in den ersten Modus umzuschalten, wenn die zweite Temperatur gleich oder kleiner als ein erster Schwellenwert ist,
- den Modus in den zweiten Modus umzuschalten, wenn die zweite Temperatur gleich oder größer als ein zweiter Schwellenwert ist,
- in einem Fall, in dem die zweite Temperatur größer als der erste Schwellenwert und kleiner als der zweite Schwellenwert ist, eine SOC-Berechnung der Batterie auf der Grundlage einer dritten Temperatur, die durch eine Gleichung "W × (erste Temperatur) + (1 - W) × (zweite Temperatur)" unter Verwendung eines Gewichts berechnet wird, durchzuführen, und
- das Gewicht W mit steigender zweiter Temperatur von 1 auf 0 zu reduzieren, wenn die SOC-Berechnung auf der Grundlage der dritten Temperatur durchgeführt wird.

7. Batteriesteuerungsvorrichtung nach Anspruch 3,

wobei ein Erwärmungszustandssignal, das einen Erwärmungszustand anzeigt, in dem die Temperatur des Mediums ansteigt, eingegeben wird, und
die erste SOC-Berechnungseinheit (151) so konfiguriert ist, dass sie den Modus in den ersten Modus umschaltet, wenn das Erwärmungszustandssignal empfangen wird, anstatt die Umschaltung abhängig von der Größe der zweiten Temperatur durchzuführen, und dass sie den Modus in den zweiten Modus umschaltet, wenn kein Erwärmungszustandssignal empfangen wird.

8. Batteriesteuergerät nach einem der Ansprüche 1 bis 3,
wobei die zweite Temperatur ein Durchschnittswert der Mehrzahl von Temperaturen oder ein Durchschnittswert der Mehrzahl von Temperaturen mit Ausnahme der ersten Temperatur ist.

**Revendications**

1. Dispositif de commande de batterie, comprenant :

une première unité (151) de calcul d'état de charge, SOC, qui est configurée pour calculer un premier état de charge (SOCv) de batterie sur la base d'une température et d'une valeur de tension d'une batterie ; et
une deuxième unité (152) de calcul de SOC qui est configurée pour calculer un deuxième état de charge (SOCi) de batterie sur la base d'une valeur de courant de la batterie,
dans lequel le dispositif de commande de batterie est configuré pour commander la charge/décharge de la batterie sur la base d'un troisième état de charge (SOC) de batterie sur la base du premier état de charge (SOCv) de batterie et du deuxième état de charge (SOCi) de batterie,
**caractérisé en ce que** la température inclut une pluralité de températures mesurées en des positions multiples de la batterie, et
la première unité (151) de calcul de SOC est configurée pour commuter

- un premier mode dans lequel un calcul de SOC de la batterie est exécuté sur la base d'une première température sur un côté haute température de la batterie et
- un deuxième mode dans lequel le calcul de SOC de la batterie est exécuté sur la base d'une deuxième température sur un côté basse température de la batterie sur la base d'une grandeur de la deuxième température.

2. Dispositif de commande de batterie selon la revendication 1, dans lequel

le dispositif de commande de batterie est configuré pour commuter sur le premier mode dans un cas où la deuxième température est inférieure à une température de seuil sur la base d'un taux de changement d'une résistance interne de la batterie, et
le dispositif de commande de batterie est configuré pour commuter sur le deuxième mode dans un cas où la deuxième température est égale ou supérieure à la température de seuil.

3. Dispositif de commande de batterie selon la revendication 1 ou 2, dans lequel
la première température est une température d'un milieu qui transfère de la chaleur avec la batterie.

4. Dispositif de commande de batterie selon l'une quelconque des revendications 1 à 3, dans lequel

dans un cas où une différence entre la première température et la deuxième température est plus grande qu'une valeur prédéterminée, la première unité (151) de calcul de SOC est configurée pour exécuter une commutation sur la base d'une grandeur de la deuxième température, et
le dispositif de commande de batterie est configuré pour commuter sur le deuxième mode dans un cas où la différence est égale ou inférieure à la valeur prédéterminée.

5. Dispositif de commande de batterie selon la revendication 2, dans lequel

dans un cas où la deuxième température est inférieure à la température de seuil en rapport à une précision de calcul de SOC,
la première unité (151) de calcul de SOC est configurée pour exécuter un calcul de SOC de la batterie sur la base de la première température dans un cas où une différence entre la première température et la deuxième température est plus petite qu'une valeur prédéterminée, et
la première unité (151) de calcul de SOC est configurée pour exécuter le calcul de SOC de la batterie sur la base d'une température obtenue en ajoutant une quantité de correction égale ou inférieure à la valeur prédéterminée à la deuxième température dans un cas où la différence est égale ou supérieure à la valeur prédéterminée.

6. Dispositif de commande de batterie selon la revendication 1,
dans lequel la première unité (151) de calcul de SOC est configurée pour :

- commuter le mode sur le premier mode dans un cas où la deuxième température est égale ou inférieure à un premier seuil,
- commuter le mode sur le deuxième mode dans un cas où la deuxième température est égale ou supérieure à un deuxième seuil,
- exécuter un calcul de SOC de la batterie sur la base d'une troisième température calculée par une équation « W $\times$ (première température) + (1 - W) $\times$ (deuxième température) » en utilisant un poids W dans un cas où la deuxième température est plus grande que le premier seuil et plus petite que le deuxième seuil, et
- réduire le poids W de 1 à 0 alors que la deuxième température s'élève lorsque le calcul de SOC est exécuté sur la base de la troisième température.

7. Dispositif de commande de batterie selon la revendication 3,

dans lequel un signal d'état d'échauffement indiquant un état d'échauffement où le milieu augmente en température est entré, et
la première unité (151) de calcul de SOC est configurée pour commuter le mode sur le premier mode lorsque le signal d'état d'échauffement est reçu au lieu d'exécuter la commutation en fonction de la grandeur de la deuxième température, et pour commuter le mode sur le deuxième mode lorsqu'aucun signal d'état d'échauffement n'est reçu.

8. Dispositif de commande de batterie selon l'une quelconque des revendications 1 à 3,
dans lequel la deuxième température est une valeur moyenne de la pluralité de températures ou une valeur moyenne de la pluralité de températures à l'exception de la première température.

*FIG. 1*

*FIG. 2*

EP 3 534 168 B1

## FIG. 3

EP 3 534 168 B1

*FIG. 4*

*FIG. 5*

EP 3 534 168 B1

EP 3 534 168 B1

FIG. 6

FIG. 7

EP 3 534 168 B1

# FIG. 8

FIRST MODE
TEMPERATURE REGION

SECOND MODE
TEMPERATURE REGION

$(\Delta R / \Delta T)$: LARGE

$(\Delta R / \Delta T) = dRth1$

$(\Delta R / \Delta T)$: SMALL

Tth1

TEMPERATURE
(Tmode2)

EP 3 534 168 B1

## FIG. 9

S10

$(\Delta R/\Delta T) > dRth1$

YES

NO

S20

**<FIRST MODE SELECTION>**
INPUT TEMPERATURE Tin = Tmode1

S30

**<SECOND MODE SELECTION>**
INPUT TEMPERATURE Tin = Tmode2

## FIG. 10

EP 3 534 168 B1

EP 3 534 168 B1

## FIG. 11

*FIG. 12*

EP 3 534 168 B1

FIG. 13

# FIG. 14

EP 3 534 168 B1

## FIG. 15

S15

Tmode2 < Tth1

YES

S20

<FIRST MODE SELECTION>
INPUT TEMPERATURE Tin = Tmode1

NO

S30

<SECOND MODE SELECTION>
INPUT TEMPERATURE Tin = Tmode2

# FIG. 16

EP 3 534 168 B1

EP 3 534 168 B1

# FIG. 17

FIG. 18

S110

$\Delta Tdf1 > Tdfa$

NO

YES

S10

$(\Delta R / \Delta T) > dRth1$

YES

NO

S20

<FIRST MODE SELECTION>
INPUT TEMPERATURE Tin = Tmode1

S30

<SECOND MODE SELECTION>
INPUT TEMPERATURE Tin = Tmode2

# FIG. 19

EP 3 534 168 B1

FIG. 20

EP 3 534 168 B1

FIG. 21

# FIG. 22

EP 3 534 168 B1

# FIG. 24

EP 3 534 168 B1

## FIG. 25

EP 3 534 168 B1

**EP 3 534 168 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 201235873 A1
- US 20130200845 A1
- JP 2012026869 A